# EUROPÄISCHE PATENTSCHRIFT

(11) **EP 1 742 227 B1**
(45) Veröffentlichungstag und Bekanntmachung des Hinweises auf die Patenterteilung: **12.03.2008**
(21) Anmeldenummer: 06011016.0
(22) Anmeldetag: 29.05.2006
(51) Int. Cl.: G11C 14/00

(54) **Bistabile Kippstufe mit nichtflüchtiger Zustandsspeicherung**
Bistable flip flop circuit with non-volatile backup memorizing
Bascule bistable avec mémorisation nonvolatile de backup

(30) Priorität: 28.06.2005 DE 102005030142
(43) Veröffentlichungstag der Anmeldung: 10.01.2007
(73) Patentinhaber: Qimonda AG, 81739 München (DE)
(72) Erfinder: Schoenauer, Tim, 85622 Feldkirchen (DE); Niedermeier, Thomas, 83024 Rosenheim (DE); Kund, Michael, 83104 Tuntenhausen (DE); Berthold, Joerg, 81675 München (DE)
(74) Vertreter: Patentanwälte Lambsdorff & Lange

(56) Entgegenhaltungen:
- US-A1- 2004 141 363

## Beschreibung

Die Erfindung betrifft eine nichtflüchtige Speicherzelle mit einem flüchtigen Speichermittel, insbesondere mit einer bistabilen Kippstufe, und einem Widerstandselement mit binär programmierbarem Widerstandswert zur nichtflüchtigen Sicherung der in dem flüchtigen Speichermittel gespeicherten binären Information. Außerdem betrifft die Erfindung ein aus derartigen nichtflüchtigen Speicherzellen aufgebautes Schieberegister.

Mit zunehmender Anzahl verlustleistungssensibler Anwendungen monolithisch integrierter Schaltungen, insbesondere im Bereich mobiler Applikationen, als auch mit steigender Verlustleistungsaufnahme aufgrund zunehmender Komplexität dieser Schaltungen erscheint es notwendig, in einem sogenannten Power-Down-Modus temporär nicht genutzte Schaltungsblöcke mit reduzierter Verlustleistung zu betreiben oder gar ganz abzuschalten. Für einige Applikationen ist es von Vorteil, wenn die zur Zustandsspeicherung in sequentiellen Schaltungsblökken, insbesondere Logikblöcken, verwendeten Latches oder Flipflops beim Übergang vom normalen Betriebsmodus in den Power-Down-Modus ihren Speicherzustand sichern, so dass sich der jeweilige Schaltungsblock nach dem Übergang vom Power-Down-Modus in den normalen Betriebsmodus und dem Wiederabrufen der gesicherten Speicherzustände wieder in seinem vorherigen Zustand befindet. Derartige Flipflops oder Latches, welche neben bistabilen Kippstufen zum flüchtigen Speichern über einen zusätzlichen Speicher zum Sichern und Halten des Speicherzustands während des Betriebs im Power-Down-Modus verfügen, werden auch als Retention-Flipflops bzw. Retention-Latches bezeichnet.

Dieses Konzept der Sicherung der Speicherzustände im Power-Down-Modus kann in ähnlicher Weise auch für andere Schaltungsapplikationen, welche bistabile Kippstufen zur Datenspeicherung verwenden, genutzt werden, beispielsweise für SRAM (SRAM: static random access memory) oder für PLD-Konfigurationsspeicher (programmable logic devices).

Bei der Implementierung derartiger Retention-Flipflops oder Retention-Latches (nur eine Kippstufe) sind im Stand der Technik grundsätzlich zwei Arten von Retention-Flipflops bzw. Retention-Latches bekannt: einerseits Speicherzellen, welche in reiner CMOS-Technologie implementiert sind (complementary metal oxide semiconductor), und andererseits Speicherzellen, welche auf einer Kombination von CMOS-Technologie und nichtflüchtiger Speichertechnologie beruhen.

Bei der Implementierung in reiner CMOS-Technologie wird typischerweise zusätzlich zu der primären Versorgungsspannung eine zweite Versorgungsspannung vorgesehen, welche im Gegensatz zu der primären Versorgungsspannung während des Power-Down-Modus nicht abgeschaltet wird. Ein derartiges Retention-Flipflop ist aus den Druckschriften US 5,473,571 sowie "A 1-V High-speed MTCMOS Circuit Scheme for Power-down Application Circuits", Shigematsu et al., Journal of Solid State Circuits, Juni 1997, Seiten 861 bis 869, bekannt. Dabei wird ein zusätzliches Latch, welches über die zweite Versorgungsspannung gespeist wird, dazu verwendet, den Speicherzustand des Flipflops während des Power-Down-Modus zu sichern. Falls das Flipflop nach dem Power-Down-Modus wieder mit der primären Versorgungsspannung gespeist wird, kann der gesicherte Speicherzustand wieder in den mit der primären Versorgungsspannung betriebenen Schaltungsteil des Flipflops rückübertragen werden. Ein derartiges Retention-Flipflop wird im Stand der Technik häufig als Balloon-Flipflop bezeichnet, wobei das mit der zweiten Versorgungsspannung betriebene Latch als Balloon-Latch bezeichnet wird.

Aus dem Stand der Technik (so beispielsweise US 2003/0188241 und US 2004/051574) sind eine Vielzahl von Retention-Flipflops bekannt, welche auf dem in der vorstehend genannten Druckschrift beschriebenen Balloon-Flipflop basieren und einen reduzierten Flächenbedarf oder eine höhere Datenrate aufweisen.

Auf reiner CMOS-Technologie basierende Retention-Flipflops weisen eine Vielzahl von Nachteilen auf. Eine wesentliche Eigenschaft der reinen CMOS-Technologie ist deren Speicherflüchtigkeit (volatility), d. h. dass diese lediglich zur flüchtigen Datenspeicherung verwendet werden kann. Wird die Versorgungsspannung abgeschaltet, geht der Dateninhalt verloren. Aus diesem Grund besteht generell die Notwendigkeit, eine zweite Versorgungsspannung vorzusehen, welche im Power-Down-Modus aktiv bleibt. Dies kostet zusätzliche Chipfläche, da die zweite Versorgungsspannung auf dem Chip verteilt werden muss. Außerdem belegt ein derartiges Balloon-Flipflop im Vergleich zu einem gewöhnlichen Flipflop ohne Datensicherung generell eine größere Chipfläche. Der zusätzliche Flächenbedarf eines derartigen Flipflops entspricht typischerweise mehr als 50% der Chipfläche eines gewöhnlichen Flipflops. Außerdem fließt während des Power-Down-Modus in dem Balloon-Latch ein Leckstrom, welcher mit einer zusätzlichen Verlustleistung während des Power-Down-Modus verbunden ist. Der Leckstrom kann dadurch reduziert werden, dass Transistoren mit betragsmäßig großer Threshold-Spannung verwendet werden.

Die vorstehend genannten Nachteile können größtenteils dadurch behoben werden, dass nichtflüchtige Speichertechnologien bei der Implementierung eines Retention-Flipflops verwendet werden.

Für diesen Zweck eignet sich besonders die sogenannte PCM-Technologie (phase change memory), welche nachfolgend kurz beschrieben wird. Die PCM-Technologie ist momentan im Fokus intensiver Forschung, insbesondere im Zusammenhang mit Matrixspeichern. Die PCM-Technologie ermöglicht es, den Wert eines Widerstandselements zu programmieren, wobei die Programmierung nichtflüchtig ist und somit beim Abschalten der Versorgungsspannung erhalten bleibt. Die PCM-Technologie beruht darauf, den Phasenzustand von einem chalcogeniden Glas thermisch in reversibler Weise zwischen dem amorphen und dem polykristallinen Zustand zu wechseln. Dabei ist der spezifische Widerstand eines aus chalcogenidem Glas bestehenden Widerstandselements im amorphen Zustand größer als im polykristallinen Zustand. Der Wechsel des Phasenzustands wird durch Wärme hervorgerufen, welche mittels eines Strompulses durch das Widerstandselement erzeugt wird. Dabei bestimmt die Dauer und die Stromstärke des Strompulses, ob das Widerstandselement anschließend einen hohen oder geringen Widerstandswert aufweist.

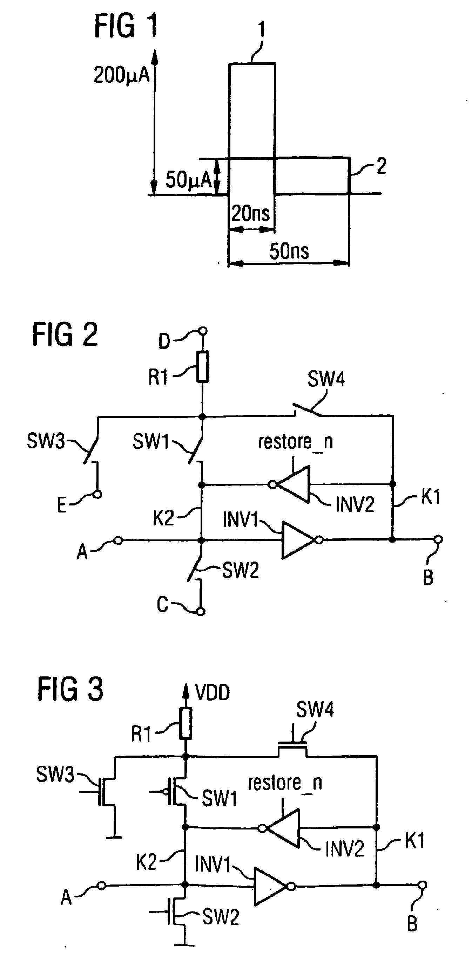

In Fig. 1 sind zwei Strompulse 1 und 2 zur Programmierung eines derartigen Widerstandselements dargestellt. Mittels des Strompulses 1 mit einer relativ hohen Stromstärke von 200 µA und einer relativen geringen Pulsdauer von 20 ns wird das Widerstandselement in den amorphen Zustand mit einem Widerstandswert von 1 MΩ überführt, während mittels des Strompulses 2 mit einer relativ geringen Stromstärke von 50 µA und einer relativ großen Pulsdauer von 50 ns das Widerstandselement in den polykristallinen Zustand mit einem Widerstandswert von 10 kΩ transformiert wird.

Ein entscheidender Vorteil der PCM-Technologie gegenüber anderen nichtflüchtigen Speichertechnologien ist, dass eine Reduzierung in den Abmessungen der speichernden Elemente nicht nur unproblematisch, sondern sogar vorteilhaft ist. Je kleiner die verwendeten Strukturen sind, desto geringer ist die nötige Stromstärke des den Phasenwechsel initiierenden Strompulses. Darüber hinaus können PCM-Widerstandselemente in den oberen Schichten eines CMOS-Halbleiterprozesses realisiert werden, so dass die Widerstandselemente über den Transistoren angeordnet werden können, beispielsweise jeweils direkt über den einer Speicherzelle zugeordneten Transistoren.

In der Druckschrift US 2004/0141363 A1 ist die Anwendung der PCM-Technologie im Zusammenhang mit SRAM-Speicherzellen beschrieben. Gewöhnliche SRAM-Speicherzellen umfassen jeweils zur flüchtigen Informationsspeicherung eine bistabile Kippstufe in Form zweier kreuzgekoppelter Inverter, wobei die binäre Information dem Potentialwert der beiden Ausgangsknoten der beiden Inverter entspricht. Bei der in dieser Druckschrift beschriebenen SRAM-Speicherzelle wird außerdem an jeden der beiden Knoten über einen schaltbaren Koppel-NMOS-Transistor ein Widerstandselement angeschlossen, wobei die beiden Widerstandselemente auf einen gemeinsamen Knoten ("plate line") mit dem Potential PL geführt sind. Die beiden als Schalter fungierenden Koppel-Transistoren werden Gateseitig über ein digitales Signal CL (common control signal line) gesteuert.

Zum Sichern der in der bistabilen Kippstufe abgespeicherten binären Information werden beide Widerstandselemente zunächst mittels einer geeigneten Pulssequenz der Signale CL und PL und damit verbundener Strompulse in den hochohmigen Zustand versetzt (Phase-Change-Reset-Operation oder PC-Reset-Operation). Anschließend wird mittels eines geeigneten Pulses des Signals CL genau ein einziges der beiden Widerstandselemente auf einen niederohmigen Widerstandswert programmiert (Save-Operation). Dabei hängt es von dem Zustand der beiden Ausgangsknoten ab, welches der beiden Widerstandselemente programmiert wird. Die Unterscheidung zwischen der PC-Reset-Operation (Zurücksetzen auf den hochohmigen Zustand) und der Save-Operation (Programmieren des niederohmigen Zustands) kann anhand der Pulslänge oder der Puls-Amplitude erfolgen.

Zum Wiederabrufen der in den beiden Widerstandselementen gesicherten binären Information werden mittels eines geeigneten Pulses des Signals CL die Koppel-Transistoren während der Pulsdauer leitend geschaltet. Das Potential PL wird rampenförmig auf die Versorgungsspannung hochgefahren. In Abhängigkeit des Widerstandswerts der beiden Widerstandselemente werden die beiden Ausgangsknoten mit unterschiedlicher Geschwindigkeit umgeladen. Gleichzeitig wird die Versorgungsspannung der Inverter eingeschaltet, so dass diese entsprechend des Ladezustands der vorgeladenen Ausgangsknoten kippen.

Die vorstehend beschriebene SRAM-Speicherzelle weist eine Vielzahl von Nachteilen auf:
Einerseits werden als Koppel-Transistoren NMOS-Transistoren verwendet, welche zwar ohne Spannungsabfall das Massepotential schalten können, welche jedoch nicht den gesamten positiven Spannungshub in Höhe der positiven Versorgungsspannung übertragen können. Folglich kann es beim Sichern der binären Information unter Umständen zu Programmierfehlern kommen. Dies kann zwar dadurch vermieden werden, dass statt zweier Koppel-Transistoren zwei Transmission-Gates bestehend aus einem NMOS- und einem PMOS-Transistor verwendet werden. Bei einem Transmission-Gate schaltet der NMOS-Transistor das Massepotential verlustfrei, während der PMOS-Transistor das positive Versorgungspotential verlustfrei schaltet. Durch die Verwendung von Transmission-Gates wird jedoch die Anzahl der Transistoren um zwei Transistoren erhöht.
Nachteilig ist außerdem, dass die unterschiedliche Widerstandsprogrammierung während der PC-Reset-Operation und der Save-Operation lediglich mit Hilfe einer Variation der Pulslänge oder der Spannungsamplitude erreicht werden kann. Im Fall unterschiedlicher Spannungsamplituden muss eine zweite Versorgungsspannung vorgesehen werden, während im Fall unterschiedlicher Pulslängen schaltungstechnischer Aufwand in die Generierung der unterschiedlichen Pulslängen gesteckt werden muss.
Problematisch erscheint ferner, das Wiederabrufen der gesicherten Information in robuster Weise zu gewährleisten. Die zum Wiederabrufen der gesicherten Information notwendige Abfolge bestehend aus dem rampenförmigen, langsamen Hochfahren des Potentials PL, dem dazu synchronisierten rampenförmigen, schnellen Hochfahren der Versorgungsspannung der bistabilen Kippstufe und dem Puls des Signals CL zum Einschalten der Koppel-Transistoren erfordert einen hohen schaltungstechnischen Aufwand. Dabei muss sichergestellt werden, dass der Ausleseprozess ausreichend robust ist und die Widerstandsinformation beim Auslesen nicht gelöscht wird (destruktives Auslesen).

Darüber hinaus sind die Potentiale der Speicherknoten der bistabilen Kippstufe vor dem Wiederabrufen der gesicherten Information völlig undefiniert. Dies kann dazu führen, dass die bistabile Kippstufe nach dem Einschalten nicht in den gewünschten Zustand schaltet. Beim Wiederabrufen der gesicherten Information ist eines der beiden Widerstandselemente hochohmig, so dass beim Hochfahren des Signals PL das Potential des mit diesem Widerstandselement verbundenen Speicherknotens sich nur geringfügig ändert. Für den Fall, dass beim Wiederabrufen der gesicherten Information dieser Knoten nicht auf dem Massepotential liegt, ist es denkbar, dass die Potentialänderung zu gering ist, um ein Schalten der Kippstufe in den gewünschten Zustand zu ermöglichen. In diesem Fall arbeiten die beiden Inverter der Kippstufe gegeneinander.

Außerdem erweist sich die Verwendung zweier Widerstandselemente im Layout der Speicherzelle als problematisch. Da diese Widerstandselemente typischerweise in den oberen Metalllagen angeordnet sind, belegen die Verbindungen zwischen den Widerstandselementen und den restlichen Schaltungselementen einen relativ großen Teil der zur Verdrahtung vorgesehenen Metalllagen.

Es ist Aufgabe der Erfindung, zu der aus dem Stand der Technik bekannten nichtflüchtigen Speicherzelle eine alternative nichtflüchtige Speicherzelle anzugeben, bei welcher die nichtflüchtige Informationssicherung mittels einer Widerstandsprogrammierung erfolgt, wobei der Schaltungsaufwand gegenüber dem Stand der Technik reduziert ist. Außerdem ist es Aufgabe der Erfindung, ein Schieberegister anzugeben, welches eine Mehrzahl erfindungsgemäßer nichtflüchtiger Speicherzellen umfasst.

Die der Erfindung zugrunde liegenden Aufgabenstellungen werden durch die Merkmale der unabhängigen Ansprüche 1 und 25 gelöst.

Die erfindungsgemäße nichtflüchtige Speicherzelle weist ein flüchtiges Speichermittel mit einem oder mehreren Speicherknoten zur Speicherung einer binären Information in Form des Potentialwerts eines ersten Speicherknotens auf. Vorteilhafterweise ist dafür eine bistabile Kippstufe in Form zweier kreuzgekoppelter CMOS-Inverter vorgesehen. Ferner umfasst die nichtflüchtige Speicherzelle lediglich ein einziges Widerstandselement mit binär programmierbarem Widerstandswert zum nichtflüchtigen Sichern der in dem flüchtigen Speichermittel gespeicherten binären Information. Darüber hinaus weist die nichtflüchtige Speicherzelle ein Mittel zum Sichern der binären Information in dem Widerstandselement auf. Dieses ist derart ausgestaltet, dass der Widerstandswert in Abhängigkeit des Potentials des ersten Speicherknotens programmiert wird. Außerdem ist ein Mittel zum Wiederabrufen der in Form des Widerstandswerts gesicherten binären Information vorhanden.

Der erfindungsgemäßen nichtflüchtigen Speicherzelle liegt der Gedanke zugrunde, dass zur binären Informationssicherung die Verwendung zweier Widerstandselemente wie im Stand der Technik nicht notwendig ist und den Schaltungsaufwand unnötig erhöht. Stattdessen reicht es aus, lediglich ein einziges Widerstandselement für diese Aufgabe vorzusehen, wobei jedem Widerstandswert dieses Widerstandselements einer der beiden Zustände des flüchtigen Speichermittels zugeordnet ist.

Durch die Verwendung lediglich eines einzigen Widerstandselements zum Sichern der binären Information lässt sich der Schaltungsaufwand für die nichtflüchtige Speicherzelle reduzieren. Insbesondere ist die Verwendung eines einzigen Widerstandselements für das Layout der Speicherzelle vorteilhaft, da nur ein einziges, typischerweise zwischen zwei oberen Metalllagen angeordnetes Widerstandselement angeschlossen werden muss. Hierdurch wird nur ein geringer Teil der für die Verdrahtung vorgesehenen Metalllagen belegt. Außerdem wird durch die Verwendung eines einzigen Widerstandselements die Anzahl der Schaltungselemente reduziert, die der Programmierung und dem Wiederabrufen der gesicherten Information dienen.

Vorteilhafterweise handelt es sich bei dem Widerstandselement um ein PCM-Widerstandselement, welches in dem amorphen Zustand einen großen Widerstandswert und in dem polykristallinen Zustand einen geringen Widerstandswert aufweist. Es wäre jedoch auch denkbar, alternative Speichertechnologien zu verwenden, bei denen wie bei der PCM-Technologie die Informationsspeicherung anhand der Widerstandsprogrammierung eines Widerstandselements erfolgt. Als ein Beispiel für eine derartige alternative Speichertechnologie sei hier auf die PMC-Technologie (programmable metallization cell) verwiesen. Die PMC- und PCM-Technologie werden allgemein unter dem Begriff "ionic memory" zusammengefasst.

Das Mittel zum Wiederabrufen der binären Information ist typischerweise derart ausgestaltet, dass dieses den Potentialwert eines zweiten, nicht notwendigerweise von dem ersten Speicherknoten verschiedenen Speicherknotens dieser Speicherzelle festlegt, d. h. der erste Speicherknoten und der zweite Speicherknoten können dieselben oder unterschiedliche Knoten sein. Alternativ kann vorgesehen sein, dass dieses Mittel den Speicherknoten einer anderen identischen Speicherzelle in Abhängigkeit des Widerstandswerts festlegt. Im zweiten Fall wird die in Form des Widerstandswerts gesicherte Information statt in die ursprüngliche Speicherzelle in eine andere Speicherzelle übertragen.

Es ist von Vorteil, wenn das Mittel zum Wiederabrufen der binären Information ein Mittel zum Initialisieren des Potentials des zweiten Speicherknotens mit einem festen Wert, beispielsweise mit dem Massepotential (VSS) oder dem positiven Betriebsspannungspotential (VDD), umfasst. Hierdurch lässt sich der zweite Speicherknoten vor dem eigentlichen Wiederabrufen der binären Information in einen definierten Zustand versetzen. Diese Maßnahme verhindert, dass das Wiederabrufen der binären Information von dem Zustand des zweiten Speicherknotens vor dem Wiederabrufen beeinflusst wird. Für den Fall, dass beim Wiederabrufen der gesicherten Information das Widerstandselement hochohmig ist, wird während des Wiederabrufens das Potential des zweiten Speicherknotens über das Widerstandselement nur geringfügig geändert. Falls der Zustand des zweiten Speicherknotens undefiniert ist, ist die Potentialänderung ausgehend von einem ungünstigen Potentialwert möglicherweise zu gering, um das flüchtige Speicherelement in den gesicherten Zustand zu versetzen. Erfindungsgemäß wird jedoch der Zustand des zweiten Speicherknotens mit einem bekannten festen Wert initialisiert, so dass das flüchtige Speicherelement unabhängig von dem vorherigen Zustand des zweiten Speicherknotens sicher in den richtigen Zustand kippt. Mit Hilfe dieser Maßnahme wird also die Robustheit beim Wiederabrufen der gesicherten Information erhöht.

Für den Fall, dass das flüchtige Speichermittel zwei kreuzgekoppelte Inverter umfasst und sich das Potential des zweiten Speicherknotens initialisieren lässt, ist es von Vorteil, wenn der Ausgang desjenigen Inverters, welcher den zweiten Speicherknoten treibt, hochohmig schaltbar oder vom zweiten Speicherknoten entkoppelbar ist. Der hochohmige Ausgangszustand wird auch als Tristate-Zustand bezeichnet. Der Ausgang wird hochohmig geschaltet bzw. vom zweiten Speicherknoten entkoppelt, wenn der zweite Speicherknoten vor dem eigentlichen Wiederabrufen der gesicherten Information mit einem festen Wert initialisiert wird.

In diesem Fall sind die beiden kreuzgekoppelten Inverter vorteilhafterweise CMOS-Inverter mit jeweils einem NMOS- und einem PMOS-Transistor. Bei einer ersten vorteilhaften Ausgestaltung der nichtflüchtigen Speicherzelle verbindet das Mittel zum Initialisieren des Potentials des zweiten Speicherknotens beim Initialisieren des Potentials den zweiten Speicherknoten mit dem Masseknoten, während der Ausgang des hochohmig schaltbaren Inverters hochohmig geschaltet ist. Bei einer dazu alternativen zweiten vorteilhaften Ausgestaltung der nichtflüchtigen Speicherzelle verbindet das Mittel zum Initialisieren des Potentials des zweiten Speicherknotens beim Initialisieren des Potentials den zweiten Speicherknoten statt mit dem Masseknoten mit dem positiven Betriebsspannungsknoten. In dem ausgangsseitig hochohmig schaltbaren Inverter ist in beiden vorteilhaften alternativen Ausgestaltungen zum Schalten des Inverterausgangs in den hochohmigen Zustand lediglich ein einziger zusätzlicher Transistor vorgesehen. In der ersten vorteilhaften Ausgestaltung ist dieser zusätzliche Transistor ein NMOS-Transistor, dessen Source-Drain-Strecke zwischen dem Masseknoten und dem Source-Anschluss des NMOS-Transistors desselben Inverters angeordnet ist, und welcher bei hochohmigem Ausgang den Masseknoten von dem Source-Anschluss des NMOS-Transistors des Inverters entkoppelt. Bei der alternativen vorteilhaften Ausgestaltung handelt es sich um einen PMOS-Transistor, dessen Source-Drain-Strecke zwischen dem positiven Betriebsspannungsknoten und dem Source-Anschluss des PMOS-Transistors desselben Inverters angeordnet ist, und welcher bei hochohmigem Ausgang den positiven Betriebsspannungsknoten von dem Source-Anschluss des PMOS-Transistors des Inverters entkoppelt.

Bei einer typischen Implementierung eines tristate-fähigen Inverterausgangs werden im Stand der Technik generell zwei zusätzliche Transistoren vorgesehen, wobei üblicherweise der erste zusätzliche Transistor und der zweite zusätzliche Transistor den hochohmigen Ausgang von dem positiven Betriebsspannungsknoten bzw. von dem Masseknoten entkoppeln. Erfindungsgemäß wird auf einen der beiden zusätzlichen Transistoren verzichtet, da der zweite Speicherknoten auf VSS oder VDD initialisiert wird. Vorausgesetzt, dass die Inverter aktiv sind, wird der Eingang des tristate-fähigen Inverters daher zwingend auf VDD bzw. VSS liegen. Somit kann ausgeschlossen werden, dass der PMOS-Transistor bzw. der NMOS-Transistor des CMOS-Inverters aktiviert werden. Ein zusätzlicher Transistor, der den PMOS-Transistor bzw. den NMOS-Transistor des CMOS-Inverters ausgangsseitig stumm schaltet, ist daher nicht notwendig.

Vorteilhaferweise umfasst das Mittel zum Sichern der binären Information ferner ein Mittel zum Initialisieren des Widerstandswerts auf einen bestimmen Wert der beiden programmierbaren Werte. Beispielsweise wird vor dem eigentlichen Sichern der in dem flüchtigen Speicherelement abgelegten Information das Widerstandselement zunächst in den hochohmigen Zustand versetzt.

Nach einer vorteilhaften Ausführungsform der erfindungsgemäßen nichtflüchtigen Speicherzelle umfasst das Mittel zum Sichern der binären Information einen ersten Schalter, insbesondere in Form eines MOS-Transistors. Dieser Schalter verbindet den ersten Speicherknoten mit dem Widerstandselement (geschlossene Schalterstellung) oder entkoppelt den ersten Speicherknoten von dem Widerstandselement (geöffnete Schalterstellung). Dabei dient der erste Schalter bei geschlossener Schalterstellung der Programmierung des Widerstandswerts in Abhängigkeit des Potentials des ersten Speicherknotens (Save-Operation). Bei geschlossener Schalterstellung fließt so bei einem der beiden Potentialzustände (beispielsweise VSS) des ersten Speicherknotens ein Strom durch das Widerstandselement, welcher das Widerstandselement umprogrammiert. Liegt der andere Potentialzustand vor, erfolgt keine Umprogrammierung des Widerstandselements.

Vorteilhafterweise weist das Mittel zum Wiederabrufen der gesicherten binären Information einen zweiten Schalter auf, insbesondere in Form eines MOS-Transistors. Dieser Schalter verbindet bei geschlossener Schalterstellung den zweiten Speicherknoten mit dem Widerstandselement. Bei geöffneter Schalterstellung entkoppelt dieser den zweiten Speicherknoten von dem Widerstandselement. Der zweite Schalter dient bei geschlossener Schalterstellung dem Wiederabrufen der gesicherten Information (Restore-Operation). Wird der zweite Schalter geschlossen, wird der zweite Speicherknoten in Abhängigkeit des zuvor programmierten Widerstandswerts umgeladen. Die binäre Information ergibt sich dabei anhand des Potentials des zweiten Speicherknotens zum Ende des Umladeprozesses.

Es ist von Vorteil, wenn für den ersten und den zweiten Schalter zwei separate Schalter verwendet werden. Hierdurch ergibt sich ein zusätzlicher Freiheitsgrad bei der Ausgestaltung der nichtflüchtigen Speicherzelle. Bei geeigneter Dimensionierung des ersten und des zweiten Schalters können die Ströme jeweils optimal in Bezug auf die Save-Operation und die Restore-Operation eingestellt werden. Hierdurch kann insbesondere verhindert werden, dass bei der Restore-Operation ein derartig großer Strom fließt, dass das Widerstandselement umprogrammiert wird (destruktives Auslesen).

Durch geeignete Wahl des Transistortyps (N- oder P-MOS) zur Implementierung des ersten bzw. des zweiten Schalters kann darüber hinaus auch der Spannungsabfall über dem programmierbaren Widerstandselement bei geschlossenem ersten bzw. zweiten Schalter unterschiedlich gewählt werden. So kann beispielsweise bei einer Implementierung mit komplementären Transistoren dafür gesorgt werden, dass bei der Save-Operation der volle Spannungshub über dem programmierbaren Widerstandselement abfällt, während bei der Restore-Operation der Spannungshub um die Schwellenspannung des leitenden Transistors reduziert ist. Dies ermöglicht einerseits die Reduzierung der Leistungsaufnahme und der thermischen Erhitzung des Widerstandselements während der Restore-Operation; andererseits kann hierdurch gewährleistet werden, dass im Lesefall gar nicht erst diejenige kritische Spannung überschritten wird, die notwendig ist, um das Widerstandselement umzuprogrammieren.

Es ist von Vorteil, wenn das Mittel zum Initialisieren des Widerstandswerts einen dritten Schalter, insbesondere in Form eines MOS-Transistors, umfasst. Dieser verbindet bei geschlossener Schalterstellung das Widerstandselement mit einem ersten Knoten festen Potentials, beispielsweise mit VSS, und entkoppelt bei geschlossener Schalterstellung das Widerstandselement von dem ersten Knoten festen Potentials. Wird der dritte Schalter für eine gewisse Dauer geschlossen, fließt ein Strompuls durch das Widerstandselement, welcher das Widerstandselement mit einem definierten Widerstandswert initialisiert (PC-Reset-Operation).

In diesem Fall ist es von Vorteil, wenn der erste Schalter zum Durchführen der Save-Operation und der dritte Schalter zum Durchführen der PC-Reset-Operation zwei separate Schalter sind. Hierdurch ergibt sich ein zusätzlicher Freiheitsgrad bei der Ausgestaltung der nichtflüchtigen Speicherzelle. Bei geeigneter Dimensionierung des ersten und des dritten Schalters können die Ströme für die Save-Operation und die PC-Reset-Operation unterschiedlich eingestellt werden. So kann bei der PC-Reset-Operation bei einer hohen Stromstärke ein hoher Widerstandswert eingestellt werden, während bei der Save-Operation in Abhängigkeit des Potentials des ersten Speicherknotens bei geringer Stromstärke ein kleiner Widerstandswert programmiert wird. Eine zusätzliche Versorgungsspannung zur Variation der Stromstärke ist daher nicht notwendig. Unter Umständen wäre es zur Vereinfachung der Schaltung sogar denkbar, dass die Pulsdauer während der Save- und der PC-Reset-Operation identisch ist und der Widerstandswert sich allein anhand der Stromstärke des jeweils durch das Widerstandselement fließenden Stroms ergibt.

Es ist von Vorteil, wenn das Mittel zum Initialisieren des Potentials des zweiten Speicherknotens einen vierten Schalter aufweist, insbesondere in Form eines MOS-Transistors. Dieser verbindet bei geschlossener Schalterstellung den zweiten Speicherknoten mit einem zweiten Knoten festen Potentials (beispielsweise VSS), während der Schalter bei geöffneter Schalterstellung den zweiten Speicherknoten von dem zweiten Knoten festen Potentials entkoppelt. Bei geschlossener Schalterstellung kann mit Hilfe des vierten Schalters der zweite Speicherknoten vor dem eigentlichen Wiederabrufen der gesicherten Information auf ein vordefiniertes Potential, beispielsweise VSS, gelegt werden, so dass die Restore-Operation nicht durch den ursprünglichen Zustand des zweiten Speicherknotens beeinflusst wird.

In einer dazu alternativen vorteilhaften Ausführungsform wird der vierte Schalter statt zur Initialisierung des zweiten Speicherknotens direkt zum Wiederabrufen der gesicherten Information verwendet. Werden der zweite und der vierte Schalter geschlossen, agieren das Widerstandselement, der geschlossene zweite Schalter und der geschlossene vierte Schalter als Spannungsteiler. Das Potential am zweiten Speicherknoten zwischen dem vierten und dem zweiten Schalter stellt sich dabei in Abhängigkeit des Widerstandswerts des Widerstandselements und damit entsprechend der gesicherten binären Information ein. Wird die gesicherte binäre Information wie vorstehend beschrieben mittels des Spannungsteilers wiederabgerufen, wird die zeitliche Synchronisierung der Schalterstellung des zweiten und vierten Schalters deutlich vereinfacht. Der zweite und der vierte Schalter können bei dieser Ausführungsform über das gleiche Signal gesteuert werden. Dabei muss zur Beschränkung der Verlustleistungsaufnahme und zur Verhinderung eines destruktiven Auslesens lediglich der Strom im Spannungsteiler begrenzt werden. Dies kann insbesondere dadurch gewährleistet werden, dass der Widerstand Rₒₙ des zweiten Schalters bei geschlossener Schalterstellung ausreichend groß gewählt wird.

Vorteilhafterweise ist das flüchtige Speichermittel in einen bestimmten Zustand rücksetzbar, d. h. das flüchtige Speichermittel weist einen Reset-Eingang auf. Dabei wird der vierte Schalter neben dem Initialisieren des zweiten Speicherknotens bzw. direkten Auslesen der gesicherten Information außerdem zum Rücksetzen des Speichermittels verwendet. Der vierte Schalter wird also doppelt genutzt, so dass die Anzahl der notwendigen Schalter um einen Schalter reduziert wird.

Bei einer vorteilhaften Implementierungsform der erfindungsgemäßen nichtflüchtigen Speicherzelle entsprechen der erste und der zweiten Knoten festen Potentials dem Masseknoten, während das Widerstandselement mit seinem zweiten Anschluss an den positiven Betriebsspannungsknoten angeschlossen ist. Der erste, zweite, dritte und vierte Schalter sind dabei in Form eines NMOS-Transistors, PMOS-Transistors, NMOS-Transistors bzw. NMOS-Transistors implementiert.

Bei einer dazu inversen vorteilhaften Implementierungsform entsprechen der erste und der zweiten Knoten festen Potentials dem positiven Betriebsspannungsknoten. In diesem Fall ist das Widerstandselement an den Masseknoten angeschlossen. Der erste, zweite, dritte und vierte Schalter sind in Form eines PMOS-Transistors, NMOS-Transistors, PMOS-Transistors bzw. PMOS-Transistors implementiert.

Vorteilhafterweise stellt die nichtflüchtige Speicherzelle ein Master-Slave-Flipflop mit einer Master-Stufe und einer Slave-Stufe dar. In diesem Fall umfasst das flüchtige Speichermittel insgesamt zwei bistabile Kippstufen, wobei die Master-Stufe die erste bistabile Kippstufe und die Slave-Stufe die zweite bistabile Kippstufe umfassen. Hierbei kann das programmierbare Widerstandselement der Master-Stufe oder der Slave-Stufe zugeordnet werden, d. h. die binäre Information der Master-Stufe bzw. der Slave-Stufe wird in dem Widerstandselement gesichert und anschließend wieder in die Master- bzw. Slave-Stufe eingelesen. Alternativ kann die binäre Information aus der Slave-Stufe (alternativ: Master-Stufe) in dem Widerstandselement gesichert werden und anschließend in die Master-Stufe (alternativ: Slave-Stufe) eingelesen werden. In diesem Fall sind der erste Speicherknoten und der zweite Speicherknoten Knoten verschiedener Kippstufen des flüchtigen Speichermittels.

Alternativ dazu kann mittels der nichtflüchtigen Speicherzelle ein Master-Slave-Flipflop realisiert werden, welches nur eine einzige bistabile Kippstufe umfasst. Vorteilhafterweise wird die bistabile Kippstufe dabei von der Master-Stufe umfasst. Die Slave-Stufe umfasst in diesem Fall das Widerstandselement, das Mittel zum Sichern der binären Information und das Mittel zum Wiederabrufen der binären Information, d. h. die binäre Information der Slave-Stufe wird statt in einer bistabilen Kippstufe in dem Widerstandselement gespeichert. Ein wesentlicher Vorteil eines derartigen Master-Slave-Flipflops ist der geringere Flächenbedarf im Vergleich zu gewöhnlichen zwei bistabile Kippstufen umfassenden Master-Slave-Flipflops.

Analog wäre es denkbar, statt der binären Information der Slave-Stufe die binäre Information der Master-Stufe in einem Widerstandselement zu speichern, wobei in diesem Fall in der Master-Stufe auf die bistabile Kippstufe verzichtet wird.

Der zweite Aspekt der Erfindung ist auf ein Schieberegister gerichtet, welches eine Mehrzahl hintereinander geschalteter nichtflüchtiger Master-Slave-Flipflops umfasst, die jeweils lediglich eine bistabile Kippstufe beinhalten. Vorteilhafterweise wird - wie vorstehend beschrieben - die binäre Information der Slave-Stufe statt in einer bistabilen Kippstufe in dem Widerstandselement gespeichert. In diesem Fall legt für jede nichtflüchtige Speicherzelle des Schieberegisters jeweils das Mittel zum Wiederabrufen der binären Information den Potentialwert des zweiten Speicherknotens des der jeweiligen Speicherzelle nachgeschalteten Speicherzelle in Abhängigkeit des Widerstandswerts fest.

Ein derartiges Schieberegister, bei welchem die Slave-Stufe eines Master-Slave-Flipflops mittels des nichtflüchtigen Widerstandselements realisiert wird, ist wesentlich flächeneffizienter als gewöhnliche Schieberegister, die pro Master-Slave-Flipflop jeweils zwei Kippstufen umfassen. Das erfindungsgemäße Schieberegister eignet sich insbesondere dazu, eine Folge von binären Konfigurationsdaten seriell in einen Halbleiterbaustein einzulesen. In diesem Fall können die binären Konfigurationsdaten in den Widerstandselementen verlustleistungseffizient gespeichert werden. Außerdem werden die Konfigurationsdaten auf nichtflüchtige Weise in den Widerstandselementen gespeichert, so dass der Halbleiterbaustein die Konfigurationsdaten auch beim Ausschalten des Halbleiterbausteins behält.

Weitere vorteilhafte Ausgestaltungen der Erfindung sind in den Unteransprüchen angegeben.

Die Erfindung wird nachfolgend anhand mehrerer Ausführungsbeispiele unter Bezugnahme auf die Zeichnungen näher erläutert; in diesen zeigen:
- Fig. 1: zwei idealisierte Strompulse zur Programmierung von PCM-Widerstandselementen;
- Fig. 2: ein vereinfachtes Prinzipschaltbild für eine erste Mehrzahl von Ausführungsbeispielen der erfindungsgemäßen nichtflüchtigen Speicherzelle;
- Fig. 3: ein auf Fig. 2 basierendes Ausführungsbeispiel der erfindungsgemäßen nichtflüchtigen Speicherzelle;
- Fig. 4: ein erstes Ausführungsbeispiel der kreuzgekoppelten Inverter;
- Fig. 5: ein zweites Ausführungsbeispiel der kreuzgekoppelten Inverter;
- Fig. 6: ein vereinfachtes Prinzipschaltbild für eine zweite Mehrzahl von Ausführungsbeispielen der erfindungsgemäßen nichtflüchtigen Speicherzelle;
- Fig. 7: ein vereinfachtes Prinzipschaltbild für eine dritte Mehrzahl von Ausführungsbeispielen der erfindungsgemäßen nichtflüchtigen Speicherzelle;
- Fig. 8: ein erstes Ausführungsbeispiel der erfindungsgemäßen Speicherzelle in Form eines D-Flipflops;
- Fig. 9: ein Signaldiagramm für relevante Signale aus Fig. 8;
- Fig. 10: ein zweites Ausführungsbeispiel der erfindungsgemäßen Speicherzelle in Form eines D-Flipflops;
- Fig. 11: ein Ausführungsbeispiel des erfindungsgemäßen Schieberegisters; und
- Fig. 12: ein Signaldiagramm für relevante Signale aus Fig. 11.

In Fig. 2 ist ein vereinfachtes Prinzipschaltbild für eine Mehrzahl von Ausführungsbeispielen der erfindungsgemäßen nichtflüchtigen Speicherzelle dargestellt. Eventuell vorgesehene taktgesteuerte Schalter zur Realisierung eines taktgesteuerten Latches sind in Fig. 2 nicht dargestellt. Die Speicherzelle umfasst eine bistabile Kippstufe zur flüchtigen Speicherung einer binären Information, welche mittels zweier kreuzgekoppelter Inverter INV1 und INV2 realisiert ist. Die binäre Information wird in Form der Potentiale der Speicherknoten K1 und K2 gespeichert. Ferner umfasst die Speicherzelle ein binär programmierbares Widerstandselement R1 (vorzugsweise ein PCM-Widerstandselement) zum Sichern der in der Kippstufe gespeicherten Information beim Übergang in den Power-Down-Modus. Des Weiteren sind zum Sichern der binären Information zwei Schalter SW3 und SW4 vorgesehen, wobei der Schalter SW3 der PC-Reset-Operation und der Schalter SW4 der Save-Operation dient. Zum Wiederabrufen der im Widerstandselement R1 gesicherten Information werden zwei Schalter SW1 und SW2 verwendet. Die beiden Knoten A und B stellen den Dateneingang und den Datenausgang der Speicherzelle dar. Bei der Verwendung der Speicherzelle in einem Flipflop ist dem Eingang typischerweise ein getaktetes Transmission-Gate vorgeschaltet (nicht dargestellt). Außerdem befindet sich in diesem Fall typischerweise ein Transmission-Gate in der Rückkopplung zwischen den kreuzgekoppelten Invertern INV1 und INV2. Falls die Speicherzelle in einem SRAM verwendet wird, werden die beiden Knoten A und B über zwei Koppel-Transistoren (nicht dargestellt) an differentielle Bitleitungen angeschlossen. Die Knoten C, D und E weisen ein festes Potential auf (entweder VSS oder VDD).

Der Ausgang des Inverters INV2 lässt sich über das digitale Signal restore_n in den Tristate-Zustand versetzen. Falls das Signal restore_n low ist, treibt der Inverter INV2 den Speicherknoten K2, andernfalls ist der Ausgang hochohmig. Alternativ könnte der Ausgang des Inverters INV2 über ein zusätzliches Transmission-Gate auch vom Speicherknoten K2 entkoppelt werden (nicht dargestellt).

In Tabelle 1 ist die Konfiguration der in Fig. 2 dargestellten nichtflüchtigen Speicherzelle für vier verschiedene Ausführungsbeispiele angegeben. Schalter, welche als NMOS-Transistoren realisiert sind, sind geschlossen, wenn das jeweilige Gate-Potential auf VDD liegt. Umgekehrt sind Schalter, welche als PMOS-Transistoren implementiert sind, dann geschlossen, wenn das jeweilige Gate-Potential auf VSS liegt.

**Tabelle 1**

| **Ausführungsform** | **Knoten A** | **Knoten B** | **Knoten C** | **Knoten D** | **Knoten E** | **Schalter SW1** | **Schalter SW2** | **Schalter SW3** | **Schalter SW4** |
|---|---|---|---|---|---|---|---|---|---|
| **1** | Eingang | Ausgang | VSS | VDD | VSS | PMOS | NMOS | NMOS | NMOS |
| **2** | Ausgang | Eingang | VSS | VDD | VSS | PMOS | NMOS | NMOS | NMOS |
| **3** | Eingang | Ausgang | VDD | VSS | VDD | NMOS | PMOS | PMOS | PMOS |
| **4** | Ausgang | Eingang | VDD | VSS | VDD | NMOS | PMOS | PMOS | PMOS |

In Fig. 3 ist ein Ausführungsbeispiel der erfindungsgemäßen Speicherzelle nach Fig. 2 dargestellt, welches der Ausführungsform 1 in Tabelle 1 entspricht. Der Knoten A dient dabei als Dateneingang, während der Knoten B den Datenausgang darstellt. Die Knoten C und E liegen auf dem Massepotential VSS, der Knoten D ist an das positive Betriebsspannungspotential VDD angeschlossen. Die Schalter SW2, SW3 und SW4 sind als NMOS-Koppel-Transistoren implementiert, während der Schalter SW1 als PMOS-Koppel-Transistor ausgeführt ist.

Die Funktionsweise der in Fig. 2 dargestellten Speicherzelle wird beispielhaft anhand der Ausführungsform 1 nach Fig. 3 erläutert.

### a) Normaler Betrieb:

Während des normalen Betriebs ist das Signal restore_n high, die Schalter SW1, SW2, SW3 und SW4 sind geöffnet und die Speicherzelle arbeitet wie ein gewöhnliches Latch.

### b) Sichern der binären Information:

Zum Sichern der Zustandsinformation der Kippstufe in dem Widerstandselement R1 wird zunächst der Schalter SW3 geschlossen, d. h. das Gate-Potential von SW3 wechselt auf high. Hierdurch wird ein Stromfluss über R1 und SW3 initiiert, welcher dazu dient, das Widerstandselement R1 in einen definierten Zustand zu versetzen, beispielsweise in den amorphen Zustand mit hohem Widerstandswert (PC-Reset-Operation). Anschließend wird der Schalter SW4 geschlossen, d. h. das Gate-Potential von SW4 wechselt auf high. Das Potential des Speicherknotens K1 bestimmt, ob ein Strom durch das Widerstandselement R1 und den Schalter SW4 fließt (Save-Operation). Falls der Speicherknoten K1 auf VDD liegt, fließt kein Strom, da die Potentiale der Knoten K1 und D einander entsprechen. Falls der Speicherknoten K1 hingegen auf VSS liegt, fließt ein Strom durch das Widerstandselement R1, da in diesem Fall die Potentiale der Knoten K1 und D unterschiedlich sind. Dieser Strom ist so dimensioniert, dass hierdurch das Widerstandselement R1 umprogrammiert wird, d. h. das Widerstandselement R1 wechselt in diesem Fall in den polykristallinen Zustand mit einem geringen Widerstandswert, wenn anfangs das Widerstandselement hochohmig initialisiert wurde. In Abhängigkeit des Speicherinhalts der Speicherzelle weist das Widerstandselement R1 nach dem Sichern des Speicherinhalts also einen hohen oder einen geringen Widerstandswert auf.

### c) Wiederabrufen der gesicherten Information:

Zum Wiederabrufen der während des Power-Down-Modus in dem Widerstandselement R1 gesicherten Information (Restore-Operation) wird zunächst der Schalter SW2 geschlossen, indem das Gate-Potential von SW2 auf high umgeschaltet wird. Hierdurch wird der Speicherknoten K2 auf ein definiertes Potential (hier: VSS) gelegt. Das Signal restore_n wird dann auf low geschaltet, so dass der Ausgang des Inverters INV2 hochohmig wird. Gleichzeitig wird der Schalter SW1 für eine bestimmte Zeitdauer geschlossen, so dass der Speicherknoten K2 in Abhängigkeit des Widerstandswerts des Widerstands R1 umgeladen wird, während der Schalter SW2 wieder geöffnet wird. Die Zeitdauer wird derart gewählt, dass bei Ablauf der Zeitdauer das Potential des Speicherknotens K2 näherungsweise VDD entspricht, wenn das Widerstandselements R1 niederohmig ist, oder das Potential des Speicherknotens K2 näherungsweise bei VSS geblieben ist, wenn das Widerstandselement R1 hochohmig ist. Nach Öffnen des Schalters SW1, wird das Signal restore_n auf high geschaltet, so dass die bistabile Kippstufe aktiviert wird. Die Kippstufe kippt dann entsprechend des Potentials am Speicherknoten K2. Das Wiederabrufen der gesicherten Information kann sowohl bei Umschalten vom Power-Down-Modus in den normalen Betrieb als auch während des normalen Betriebs durchgeführt werden.

Alternativ zu der vorstehend beschriebenen Vorgehensweise kann die gesicherte Information auch mittels eines Spannungsteilers wiederabgerufen werden, welcher aus der Serienschaltung des Widerstandselements R1 sowie der Schalter SW1 und SW2 gebildet wird, wenn die Schalter SW1 und SW2 geschlossen sind. Bei geeigneter Dimensionierung des Widerstandselements R1 sowie der Schalterwiderstände R_{on,SW1} und R_{on,SW2} bei geschlossenen Schaltern SW1 bzw. SW2 kann erreicht werden, dass das Potential des Speicherknotens K2 entweder oberhalb VDD/2 oder unterhalb VDD/2 liegt, wenn das Widerstandselement R1 hochohmig bzw. niederohmig ist. Beispielsweise kann dazu der Schalterwiderstand R_{on,SW1} im Bereich von 10 kΩ bis 25 kΩ und der Schalterwiderstand R_{on,SW2} im Bereich von 100 kΩ bis 250 kΩ gewählt werden, wenn der Widerstandswert des Widerstandselements R1 im hochohmigen und im niederohmigen Zustand 10 MΩ bzw. 10 kΩ entspricht. Am Ausgang des Inverters INV1 schaltet das Potential auf VDD oder VSS, falls das Potential des Speicherknotens K2 kleiner bzw. größer VDD/2 ist. Wenn das Signal restore_n auf VDD geschaltet wird, wird die eingeprägte Information seitens der Kippstufe übernommen. Außerdem werden die Schalter SW1 und SW2 geöffnet.

Das alternative Vorgehen beim Wiederabrufen der gespeicherten Information bietet den Vorteil, dass die zeitliche Synchronisierung der die Schalter steuernden Signale und des Signals restore_n vereinfacht wird. Dabei muss lediglich zur Beschränkung der Verlustleistungsaufnahme und zur Verhinderung eines destruktiven Auslesens der Strom im Spannungsteiler begrenzt werden. Dies kann insbesondere dadurch gewährleistet werden, dass der Widerstand R_{on,SW2} des Schalters SW2 ausreichend hoch gewählt wird.

Die in Fig. 2 und Fig. 3 dargestellten erfindungsgemäßen Speicherzellen weisen gegenüber der in der Druckschrift US 2004/0141363 A1 beschriebenen nichtflüchtigen Speicherzelle eine Vielzahl von Vorteilen auf:
1. Erfindungsgemäß wird lediglich ein einziges Widerstandselement zur nichtflüchtigen Sicherung verwendet. Hierdurch wird der Schaltungsaufwand für die nichtflüchtige Speicherzelle reduziert. Insbesondere ist die Verwendung eines einzigen Widerstandselements für das Layout der Speicherzelle vorteilhaft, da nur ein einziges, typischerweise zwischen zwei oberen Metalllagen angeordnetes Widerstandselement angeschlossen werden muss. Hierdurch wird nur ein geringer Teil der für die Verdrahtung vorgesehenen Metallflächen belegt. Außerdem wird durch die Verwendung eines einzigen Widerstandselements die Anzahl der Schaltungselemente reduziert, die der Programmierung und dem Wiederabrufen der gesicherten Information dienen.
2. Im Gegensatz zu der aus dem Stand der Technik bekannten Speicherzelle kann bei der Konfiguration der Transistoren der Schalter SW1 und SW4 gemäß Tabelle 1 der gesamte Spannungshub übertragen werden, ohne dass Transmission-Gates verwendet werden müssen. Dabei wird gewährleistet, dass über den NMOS-Transistoren das Massepotential VSS geschaltet wird, während über die PMOS-Transistoren das positive Potential VDD geschaltet wird.
3. Das erfindungsgemäße Schaltungskonzept erlaubt, dass die gespeicherte in dem Widerstandselement R1 gesicherte Information auch während des Betriebs der Kippstufe, d. h. wenn die Kippstufe mit Betriebsspannung versorgt wird, wiederabgerufen werden kann. Dies ist bei der in der Druckschrift US 2004/0141363 A1 beschriebenen Schaltung nicht möglich.
4. Das Sichern und Wiederabrufen der binären Information ist bei dem erfindungsgemäßen Schaltungskonzept wesentlich robuster, da die wesentlichen Knoten, d. h. die Speicherknoten K1 und K2, während des gesamten Ablaufs des Sicherns und Wiederabrufens der binären Information ein definiertes Potential aufweisen.
5. Darüber hinaus werden im Unterschied zum Stand der Technik für die Save-Operation und die eigentliche Restore-Operation zwei verschiedene Schalter SW4 bzw. SW1 verwendet. Hierdurch ergibt sich ein zusätzlicher Freiheitsgrad bei der Ausgestaltung der nichtflüchtigen Speicherzelle. Indem der Schalter SW1 ausreichend hochohmig dimensioniert wird, kann der maximale Strom bei Wiederabrufen der binären Information derart beschränkt werden, dass ein destruktives Auslesen verhindert wird.
6. Ferner werden im Gegensatz zum Stand der Technik auch für die Reset- und die Save-Operation zwei verschiedene Schalter SW3 bzw. SW4 verwendet. Dadurch können die Ströme für die Save-Operation und die PC-Reset-Operation unterschiedlich eingestellt werden. So kann bei der PC-Reset-Operation bei einer hohen Stromstärke ein großer Widerstandswert eingestellt werden, während bei der Save-Operation in Abhängigkeit des Potentials des Speicherknotens K1 bei geringer Stromstärke ein kleiner Widerstandswert programmiert wird. Eine zusätzliche Versorgungsspannung zur Variation der Stromstärke ist daher nicht notwendig. Unter Umständen wäre es zur Vereinfachung der Schaltung sogar denkbar, dass die Pulsdauer während der Save-und der PC-Reset-Operation identisch ist und der Widerstandswert sich allein anhand der Stromstärke des jeweils durch das Widerstandselement R1 fließenden Stroms ergibt.
7. Ferner werden bei der erfindungsgemäßen Speicherzelle gemäß Fig. 2 unterschiedliche Speicherknoten während der Save-Operation und der Restore-Operation ausgelesen bzw. beschrieben. Dieser Freiheitsgrad lässt sich bei der Realisierung eines Master-Slave-Flipflops oder eines Schieberegisters - wie im Folgenden noch beschrieben - ausnutzen.

Im Vergleich zu einem gewöhnlichen taktflankengesteuerten Latch erfordert ein taktflankengesteuertes Latch, welches auf der in Fig. 2 dargestellten Speicherzelle basiert, als zusätzlichen Schaltungsaufwand ein einziges programmierbares Widerstandselement, vier Schalter sowie die Tristate-Option für einen der beiden kreuzgekoppelten Inverter. Bei einer Geradeaus-Realisierung des taktflankengesteuerten Flipflops entsprechend Fig. 3 werden zur Implementierung der vier Schalter vier zusätzliche Transistoren sowie zur Implementierung der Tristate-Option zwei zusätzliche Transistoren benötigt, so dass sich ein zusätzlicher Schaltungsaufwand von insgesamt 6 Transistoren ergibt.

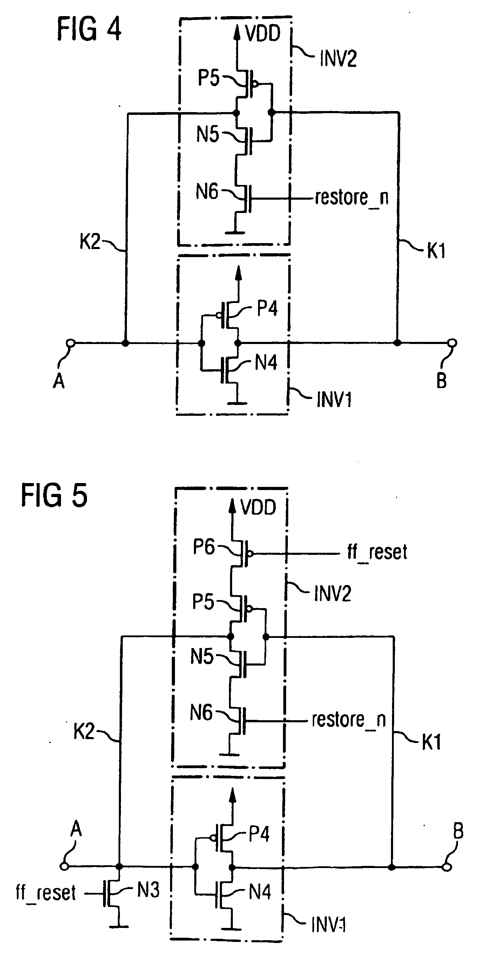

In Fig. 4 ist ein erstes Implementierungsbeispiel für die kreuzgekoppelten Inverter INV1 und INV2 aus Fig. 3 dargestellt, wobei zur Implementierung der Tristate-Option lediglich ein zusätzlicher NMOS-Transistor N6 notwendig ist, welcher den Ausgang des Inverters INV2 vom Masseknoten VSS entkoppelt, wenn das Signal restore_n auf VSS liegt. Wenn der Speicherknoten K2 über den Schalter SW2 auf VSS initialisiert wird, liegt der Eingang des Inverters INV2 zwingend auf VDD, falls die Inverter INV1 und INV2 aktiv sind. Daher kann ausgeschlossen werden, dass der PMOS-Transistor P5 des CMOS-Inverters INV2 aktiviert wird, so dass auf einen analog zu N6 am Source-Anschluss von P5 angeordneter PMOS-Transistor zur Entkoppelung des Ausgangs des Inverter INV2 vom positiven Betriebsspannungsknoten VDD verzichtet werden kann.

Wird der Speicherknoten K2 auf VDD initalisiert, ist zur Implementierung der Tristate-Option statt des NMOS-Transistors N6 lediglich ein zusätzlicher PMOS-Transistor notwendig (nicht dargestellt).

Für den Fall, dass für die bistabile Kippstufe ohnehin ein Eingriff zum Rücksetzen der Kippstufe (Reset-Funktion) vorgesehen ist, lässt sich der zusätzliche Schaltungsaufwand im Vergleich zu einem gewöhnlichen taktflankengesteuerten Latch mit Reset-Funktion weiter reduzieren. In Fig. 5 ist ein zweites Ausführungsbeispiel zur Implementierung der kreuzgekoppelten Inverter INV1 und INV2 dargestellt, welches auf dem in Fig. 4 dargestellten Ausführungsbeispiel basiert. Dabei sind die beiden zusätzlichen Transistoren P6 und N3 zur Implementierung der Reset-Funktion vorgesehen, welche über das Signal ff_reset gesteuert werden. Falls das Signal ff_reset auf VDD liegt, ist der Transistor N3 leitend und der Knoten K2 liegt auf VSS. Der gesperrte Transistor P6 verhindert gleichzeitig, dass der Inverter INV2 den Knoten K2 auf VDD zieht, d. h. dass der Inverter INV2 gegen N3 arbeitet.

Der NMOS-Transistor N3 übernimmt darüber hinaus die Funktion des Schalters SW2 aus Fig. 2, so dass in Fig. 5 lediglich der Transistor N6 zusätzlichen Schaltungsaufwand darstellt. Daher umfasst ein erfindungsgemäßes Latch mit Reset-Funktion, welches auf Fig. 5 basiert, im Vergleich zu einem gewöhnlichen Latch mit Reset-Funktion vier zusätzliche Transistoren (SW1, SW3, SW4 sowie N6) sowie ein zusätzliches einziges programmierbares Widerstandselement. Eine derartige Realisierung weist daher einen geringeren zusätzlichen Schaltungsaufwand auf als die in der Druckschrift US 2004/0141363 A1 beschriebene Lösung, welche insgesamt vier zusätzliche Transistoren (die beiden dort beschriebenen Koppel-Transistoren müssen für einen robusten Betrieb durch zwei Transmission-Gates ersetzt werden) sowie zwei zusätzliche programmierbare Widerstandselemente umfasst.

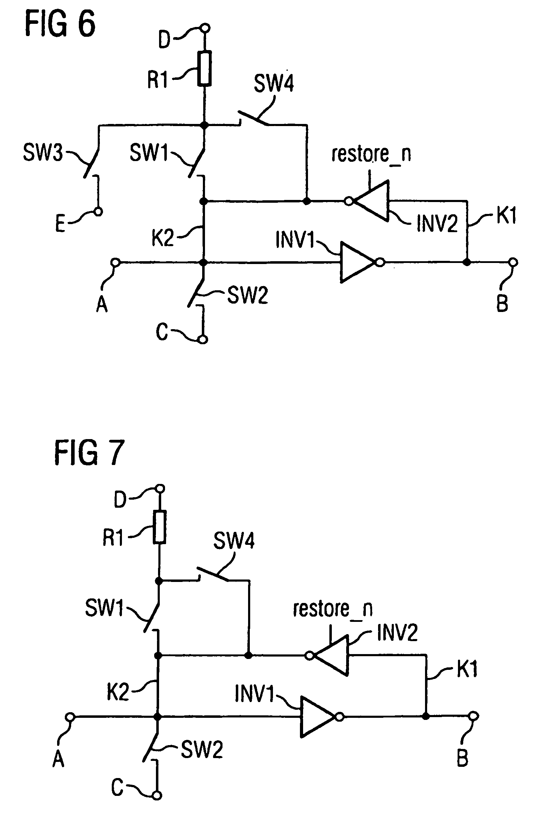

In Fig. 6 ist ein zu Fig. 2 alternatives vereinfachtes Prinzipschaltbild für eine zweite Mehrzahl von Ausführungsbeispielen der erfindungsgemäßen nichtflüchtigen Speicherzelle dargestellt, wobei vier grundsätzlich unterschiedliche Ausführungsbeispiele gemäß Tabelle 1 denkbar sind. Die Schaltung gemäß Fig. 6 arbeitet ähnlich wie die in Fig. 2 dargestellte Schaltung. Ein wesentlicher Unterschied zwischen den in Fig. 6 und Fig. 2 dargestellten Schaltungen ist, dass in Fig. 6 der Schalter SW4 mit dem Speicherknoten K2 statt mit dem Speicherknoten K1 verbunden ist. Darüber hinaus wird in Fig. 6 der Schalter SW3 dazu verwendet, das Widerstandselement niederohmig statt hochohmig wie in Fig. 2 zu initialisieren. Demzufolge dient der Schalter SW4 dazu, das Widerstandselement R1 während der Save-Operation hochohmig statt niederohmig zu programmieren, falls das Potential des Speicherknotens K2 sich von dem des Knotens D unterscheidet. Wie aus Fig. 1 ersichtlich, ist typischerweise zur Programmierung des hochohmigen Zustands eine höhere Stromstärke nötig als zur Programmierung des niederohmigen Zustands. Daher ist der Transistor zur Implementierung des Schalters SW4 in Fig. 6 generell breiter als in Fig. 2. Dies ist mit dem Nachteil verbunden, dass die mit dem Schalter SW2 im Zusammenhang stehenden parasitären Elemente in Fig. 6 generell größer als in Fig. 2 sind. Außerdem ist die parasitäre Belastung der Speicherknoten K1 und K2 in Fig. 6 wesentlicher asymmetrischer als in Fig. 2. Daher ist das in Fig. 2 dargestellte Konzept im Allgemeinen dem in Fig. 6 dargestellten Konzept vorzuziehen.

In Fig. 7 ist ein zu Fig. 2 und Fig. 6 alternatives vereinfachtes Prinzipschaltbild für eine dritte Mehrzahl von Ausführungsbeispielen der erfindungsgemäßen nichtflüchtigen Speicherzelle dargestellt, wobei vier grundsätzlich unterschiedliche Ausführungsbeispiele gemäß Tabelle 1 denkbar sind. Der wesentliche Unterschied zwischen dem Prinzipschaltbild in Fig. 6 und Fig. 7 ist, dass in Fig. 7 der separate Schalter SW3 zum Initialisieren des Widerstandselements eingespart wurde. Die Initialisierung des Widerstandselements R1 erfolgt über den Schalter SW4 (die Initialisierung über SW1 wäre auch denkbar). Das Widerstandselement R1 kann jedoch lediglich dann initialisiert werden, wenn der Knoten D und der Speicherknoten K2 unterschiedliche Potentiale aufweisen. Es bestehen mehrere Möglichkeiten, dies während der Initialisierung des Widerstandselements R1 zu gewährleisten. Unterschiedliche Potentiale für den Knoten D und den Speicherknoten K2 liegen insbesondere dann vor, wenn das Latch zurückgesetzt wird. In diesem Fall liegt beispielsweise der Knoten D auf VDD, während der Speicherknoten K2 auf VSS liegt. Nachteilig daran ist, dass die Initialisierung des Widerstandselements R1 mit einem Informationsverlust der bistabilen Kippstufe einhergeht. In diesem Fall muss die Initialisierung des Widerstandselements R1 also zeitlich vor dem Ablegen einer Information in der bistabilen Kippstufe erfolgen, beispielsweise beim Einschalten des Latches. Alternativ kann vorgesehen werden, das Potential an dem Knoten D zu wechseln. Beispielsweise wird der Knoten zunächst in einer ersten Schalterstellung auf VDD und anschließend in einer zweiten Schalterstellung auf VSS gelegt. In diesem Fall wird unabhängig von dem Speicherzustand der bistabilen Kippstufe gewährleistet, dass der Knoten D und der Speicherknoten K2 entweder in der ersten oder in der zweiten Schalterstellung unterschiedliche Potentiale aufweisen. Es sei angemerkt, dass in analoger Weise auch in Fig. 2 der Schalter SW3 eingespart werden kann.

Es sei angemerkt, dass es im Sinne der Anmeldung auch denkbar ist, die in Fig. 7 dargestellten separaten Schalter SW1 und SW4 durch einen einzigen Schalter zu ersetzen.

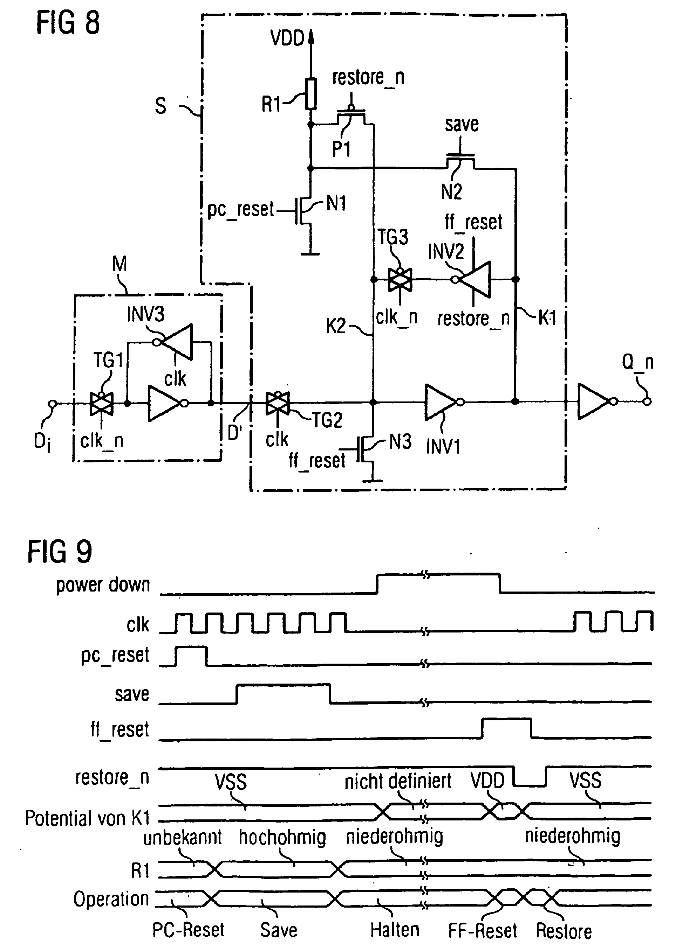

In Fig. 8 ist ein erstes Ausführungsbeispiel der erfindungsgemäßen Speicherzelle in Form eines Retention-Master-Slave-D-Flipflops dargestellt. Das Flipflop umfasst eine Master-Stufe M (Master-Latch) und eine Slave-Stufe S (Slave-Latch), wobei beide Stufen eine bistabile Kippstufe in Form zweier kreuzgekoppelter Inverter zur Informationsspeicherung umfassen. Die Slave-Stufe S basiert auf den in Fig. 3 und Fig. 5 dargestellten Schaltungen und umfasst einen Widerstand R1 zur Sicherung der in der Slave-Stufe S gespeicherten binären Information. Die Transistoren N1, N2 und P1 entsprechen den in Fig. 3 dargestellten Transistoren SW3, SW4 bzw. SW1. Das Flipflop wird über die Taktsignale clk und clk_n (invertierter Takt) gesteuert, welche von den Transmission-Gates TG1 bis TG3 sowie von dem Inverter INV3 mit hochohmig schaltbaren Ausgang entgegengenommen werden.

Das Flipflop lässt sich asynchron über das Signal ff_reset zurücksetzen, sofern die Signale restore_n und save auf VDD bzw. VSS liegen.

Zunächst wird der gewöhnliche Betrieb des Flipflops beschrieben, wobei die Signale ff_reset, restore_n, save und pc_reset auf VSS, VDD, VSS bzw. VSS liegen. Wechselt das Taktsignal clk von high nach low, wird das neue Datenbit am Dateneingang Dᵢ in invertierter Form an den Ausgang D' der Master-Stufe M weitergereicht, wobei der Ausgang des Inverters INV3 hochohmig geschaltet ist und die Kippstufe der Master-Stufe M keine Information speichert. Die Master-Stufe M und die Slave-Stufe S sind über das Transmission-Gate TG2 voneinander entkoppelt. Die bistabile Kippstufe der Slave-Stufe S hält das vorherige Datenbit. Schaltet das Taktsignal clk von low nach high, wird das Flipflop vom Eingang Dᵢ über das Transmission-Gate TG1 getrennt. Das neue Datenbit am Ausgang D' der Master-Stufe M wird über das leitende Transmission-Gate TG2 an den Datenausgang Q_n des Flipflops weitergereicht, wobei die bistabile Kippstufe der Master-Stufe M das neue Datenbit hält.

Nachfolgend wird der Prozess des Sicherns der in der Kippstufe der Slave-Stufe gespeicherten Information sowie das Wiederabrufen der gesicherten Information in Verbindung mit

Fig. 9 beschrieben. Zur Steuerung der Datensicherung und zum Wiederabrufen der gesicherten Information dienen die digitalen Steuersignale pc_reset, ff_reset, save und restore_n.

Zu Beginn der Sicherung ist der Power-Down-Modus noch deaktiviert, d. h. das entsprechende Signal power_down liegt auf VSS. Bevor die binäre Information der Kippstufe gesichert wird, wird das programmierbare Widerstandselement R1 in einen definierten Zustand versetzt (s. PC-Reset-Operation in Fig. 9). Dazu wechselt das den Transistor N1 ansteuernde Signal pc_reset von low nach high (s. Fig. 9). Dadurch wird ein Strom durch das Widerstandselement R1 und den Transistor N1 initiiert, so dass das Widerstandselement R1 hochohmig wird (amorpher Zustand).

Während der sich anschließenden Save-Operation wird das Signal save von low auf high umgeschaltet, so dass über den leitenden Transistor N2 der Speicherknoten K1 mit dem Widerstandselement R1 verbunden wird. Für den Fall, dass der Speicherknoten K1 auf VDD liegt, fließt durch das Widerstandselement R1 kein Strom, so dass das Widerstandselement R1 in dem hochohmigen Zustand verbleibt. Falls der Speicherknoten K1 auf VSS liegt (wie in Fig. 9 dargestellt), fließt ein Strom durch das Widerstandselement R1, so dass das Widerstandselement R1 in den niederohmigen Zustand (polykristalliner Zustand) versetzt wird. Der Zustand der Kippstufe der Slave-Stufe S ist nun nichtflüchtig in dem Widerstand R1 gesichert. Anschließend wird die Versorgungsspannung des Flipflops ausgeschaltet, wobei das Signal power_down auf high umschaltet.

Während die Versorgungsspannung des Flipflops ausgeschaltet ist, wird die gesicherte Information in dem Widerstand R1 gehalten. Zum Wiederabrufen der gesicherten Information ist es notwendig, dass das Taktsignal clk auf VSS liegt, so dass das Transmission-Gate TG2 sperrt und den Speicherknoten K2 vom Ausgang der Master-Stufe M entkoppelt. Das Flipflop wird wieder eingeschaltet (power_down ist low) und das Signal ff_reset schaltet auf VDD, so dass das Flipflop in einen festen Zustand zurückgesetzt wird (s. FF-Reset-Operation in Fig. 9). Dabei wird der Speicherknoten K2 über den Transistor N3 auf VSS gelegt. Anschließend wird das Signal restore_n auf VSS gelegt, so dass die Mitkopplung der Kippstufe innerhalb der Slave-Stufe S unterbrochen wird. Der Speicherknoten K2 wird lediglich durch den leitenden Koppel-Transistor P1 getrieben, welcher den Speicherknoten K2 mit VDD über das Widerstandselement R1 verbindet. In Abhängigkeit des Widerstandswerts des Widerstandselements R1 steigt das Potential am Speicherknoten an. Die Gesamtpotentialänderung hängt dabei von der Pulsdauer ab, in welcher das Signal restore_n auf VSS liegt. Bei geeigneter Wahl der Pulsdauer wird der Speicherknoten K2 auf ein Potential nahe VDD umgeladen, wenn das Widerstandselement niederohmig ist. Alternativ bleibt das Potential des Speicherknotens nahe VSS, wenn das programmierbare Widerstandselement hochohmig ist.

Der Umladeprozess lässt sich in erster Näherung mittels eines RC-Ersatzschaltbilds beschreiben. Hierbei wird beispielsweise ein Wert von C = 5 fF für die Kapazität des Speicherknotens K2 sowie ein durch das Widerstandselement R1 und den Transistor P1 gebildeter Gesamtwiderstand von R = 20 kΩ (falls R1 niederohmig ist) bzw. R· = 1 MΩ (falls R1 hochohmig ist) angenommen. Der Wert der Zeitkonstante τ = R·C des Umladeprozesses ergibt sich daher zu τ = 100 ps, falls R1 niederohmig ist, bzw. zu τ = 5 ns, falls R1 hochohmig ist. Bei einer Pulsdauer von 500 ps erreicht der Wert des Potentials am Ende des Umladeprozesses mehr als 0,9·VDD, falls R1 niederohmig ist, bzw. weniger als 0,05·VDD, falls R1 hochohmig ist. Sobald das Signal restore_n am Ende der Pulsdauer auf VDD umgeschaltet worden ist, wird die Mitkopplung der Kippstufe der Slave-Stufe S aktiviert, so dass in Abhängigkeit der Spannung an dem Speicherknoten K2 die Kippstufe in die entsprechende Richtung kippt.

In analoger Weise zu dem in Fig. 8 dargestellten Flipflop kann das Widerstandselement R1 statt der Slave-Stufe S der Master-Stufe M zugeordnet werden, so dass mittels des Widerstandselements R1 die in der Master-Stufe M gespeicherte Information gesichert wird.

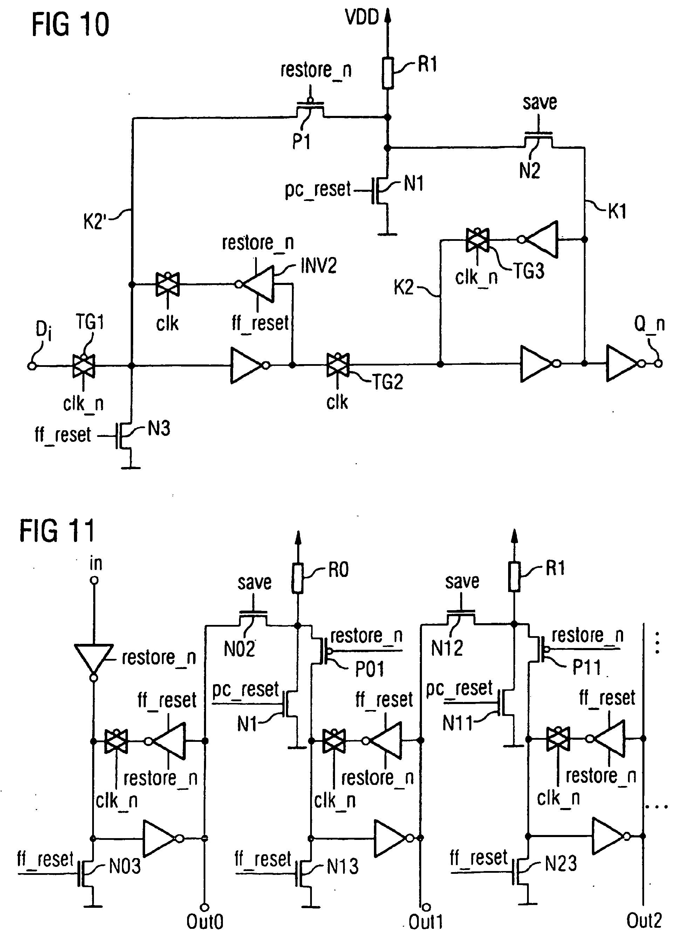

In Fig. 10 ist eine zu Fig. 8 alternative Ausführungsform für ein erfindungsgemäßes Retention-Master-Slave-D-Flipflop dargestellt. Mit gleichen Bezugszeichen versehene Schaltungselemente und Signale aus Fig. 8 und Fig. 10 entsprechen einander. In Fig. 10 wird in gleicher Weise wie in Fig. 8 die Information am Speicherknoten K1 der Slave-Stufe im Widerstandselement R1 gesichert. Im Unterschied zu der in Fig. 8 dargestellten Schaltung wird in Fig. 10 jedoch die gesicherte Information beim Wiederabrufen in den Speicherknoten K2' der Master-Stufe eingekoppelt.

In Fig. 11 ist ein Ausführungsbeispiel des erfindungsgemäßen Schieberegisters gemäß dem zweiten Aspekt der Erfindung dargestellt. In konfigurierbaren Schaltungen werden Schieberegister häufig dazu eingesetzt, um eine Folge von binären Werten seriell einzulesen. Üblicherweise benötigt man für eine Stufe eines Schieberegisters zwei Latches: ein erstes Latch, das den Wert der vorhergehenden Stufe empfängt, und ein zweites Latch, das den Wert treibt, der von der nachfolgenden Stufe empfangen wird. Das erste und das zweite Latch entsprechen der Master- bzw. Slave-Stufe eines Master-Slave-Flipflops. Ein Schieberegister, welches beispielsweise Konfigurationsdaten in nichtflüchtiger Weise abspeichert, lässt sich mittels einer Reihenschaltung der vorstehend beschriebenen erfindungsgemäßen Retention-Master-Slave-Flipflops gemäß Fig. 8 oder Fig. 10 realisieren. Um den Flächenbedarf des Schieberegisters zu reduzieren, wird bei dem Fig. 11 dargestellten Schieberegister jeweils die Slave-Stufe durch das programmierbare Widerstandselement Ri zuzüglich der Transistoren Ni2 und Ni1 zum Programmieren des Widerstandselements sowie der Transistoren Ni3 und Pi1 zum Auslesen des Widerstandselements realisiert.

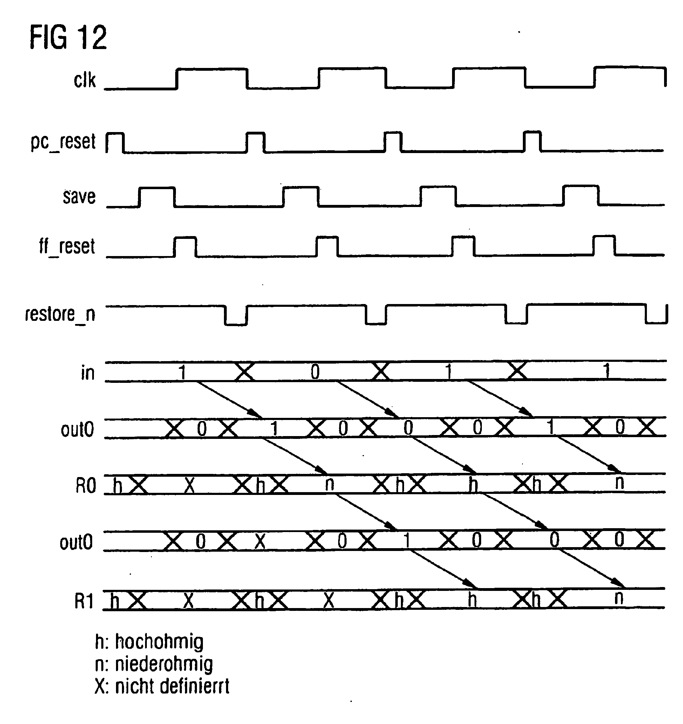

In Fig. 12 ist ein Signaldiagramm für das in Fig. 11 dargestellte Schieberegister angegeben. Über den Eingang in wird das serielle Datensignal eingespeist. Die Signale clk, clk_n, ff_reset, restore_n und pc_reset und save steuern das Schieben der Daten durch das Schieberegister. Dabei wird ein Datenbit pro Taktperiode um einen Ausgang outi weitergeschoben.

## Patentansprüche

1. Nichtflüchtige Speicherzelle, umfassend
- ein flüchtiges Speichermittel (INV1, INV2) mit einem oder mehreren Speicherknoten (K1, K2) zur Speicherung einer binären Information in Form des Potentialwerts eines ersten Speicherknotens (K1),
- ein Widerstandselement (R1) mit binär programmierbarem Widerstandswert zum nichtflüchtigen Sichern der in dem flüchtigen Speichermittel (INV1, INV2) gespeicherten binären Information,
- ein Mittel (SW3, SW4) zum Sichern der binären Information in dem Widerstandselement (R1), welches derart ausgestaltet ist, dass der Widerstandswert in Abhängigkeit des Potentials des ersten Speicherknotens (K1) programmiert wird, und
- ein Mittel (SW1, SW2) zum Wiederabrufen der in Form des Widerstandswerts gesicherten binären Information,
**dadurch gekennzeichnet, dass**
das Widerstandselement ein einziges Widerstandselement (R1) darstellt.

2. Nichtflüchtige Speicherzelle nach Anspruch 1,
**dadurch gekennzeichnet, dass**
das Mittel (SW1, SW2) zum Wiederabrufen der binären Information derart ausgestaltet ist, dass dieses den Potentialwert eines zweiten, nicht notwendigerweise von dem ersten Speicherknoten (K1) verschiedenen Speicherknotens (K2) dieser Speicherzelle oder einer anderen identischen Speicherzelle in Abhängigkeit des Widerstandswerts festlegt.

3. Nichtflüchtige Speicherzelle nach Anspruch 2,
**dadurch gekennzeichnet, dass**
das Mittel (SW1, SW2) zum Wiederabrufen der binären Information umfasst:
- ein Mittel (SW2) zum Initialisieren des Potentials des zweiten Speicherknotens (K2) mit einem festen Wert.

4. Nichtflüchtige Speicherzelle nach Anspruch 2 oder 3,
**dadurch gekennzeichnet, dass**
das Mittel (SW3, SW4) zum Sichern der binären Information umfasst:
- ein Mittel (SW3) zum Initialisieren des Widerstandswerts auf einen bestimmen Wert der beiden programmierbaren Werte.

5. Nichtflüchtige Speicherzelle nach einem der vorhergehenden Ansprüche,
**dadurch gekennzeichnet, dass**
das flüchtige Speichermittel eine bistabile Kippstufe in Form zweier kreuzgekoppelter Inverter (INV1, INV2), insbesondere zweier kreuzgekoppelter CMOS-Inverter, umfasst.

6. Nichtflüchtige Speicherzelle nach auf Anspruch 3 rückbezogenem Anspruch 5,
**dadurch gekennzeichnet, dass**
das flüchtige Speichermittel (INV1, INV2) derart ausgestaltet ist,
- dass der zweite Speicherknoten (K2) mit dem Ausgang eines Inverters (INV2) des flüchtigen Speichermittels dieser Speicherzelle oder einer anderen identischen Speicherzelle elektrisch verbunden ist, wobei der Ausgang dieses Inverters (INV2) hochohmig schaltbar oder vom zweiten Speicherknoten (K2) entkoppelbar ist.

7. Nichtflüchtige Speicherzelle nach auf Anspruch 3 rückbezogenem Anspruch 6,
**dadurch gekennzeichnet, dass**
- die beiden kreuzgekoppelten Inverter (INV1, INV2) CMOS-Inverter mit jeweils einem NMOS-Transistor (N4, N5) und einem PMOS-Transistor (P4, P5) sind,
- das Mittel (SW2; N3) zum Initialisieren des Potentials des zweiten Speicherknotens (K2) beim Initialisieren des Potentials den zweiten Speicherknoten in einer ersten Ausgestaltung mit dem Masseknoten oder in einer zweiten Ausgestaltung mit dem positiven Betriebsspannungsknoten verbindet, während der Ausgang des hochohmig schaltbaren Inverters (INV2) hochohmig geschaltet ist, und
- in dem ausgangsseitig hochohmig schaltbaren Inverter (INV2) zum Schalten des Inverterausgangs in einen hochohmigen Zustand lediglich ein einziger zusätzlicher Transistor (N6) vorgesehen ist, wobei dieser Transistor
-- in der ersten Ausgestaltung ein NMOS-Transistor ist, dessen Source-Drain-Strecke zwischen dem Masseknoten und Source-Anschluss des NMOS-Transistors (N5) desselben Inverters angeordnet ist, und welcher bei hochohmigem Ausgang den Masseknoten von dem Source-Anschluss des NMOS-Transistors (N5) des Inverters entkoppelt, und
-- in der zweiten Ausgestaltung ein PMOS-Transistor ist, dessen Source-Drain-Strecke zwischen dem positiven Betriebsspannungsknoten und dem Source-Anschluss des PMOS-Transistors desselben Inverters angeordnet ist, und welcher bei hochohmigem Ausgang den positiven Betriebsspannungsknoten von dem Source-Anschluss des PMOS-Transistors des Inverters entkoppelt.

8. Nichtflüchtige Speicherzelle nach einem der Ansprüche 2 bis 7,
**dadurch gekennzeichnet, dass**
das Mittel (SW3, SW4) zum Sichern der binären Information einen ersten Schalter (SW4), insbesondere in Form eines MOS-Transistors, umfasst, welcher wahlweise
- den ersten Speicherknoten (K1) mit dem Widerstandselement (R1) elektrisch verbindet oder
- den ersten Speicherknoten (K1) von dem Widerstandselement (R1) elektrisch entkoppelt.

9. Nichtflüchtige Speicherzelle nach einem der Ansprüche 2 bis 8,
**dadurch gekennzeichnet, dass**
das Mittel (SW1, SW2) zum Wiederabrufen der gesicherten binären Information einen zweiten Schalter (SW1), insbesondere in Form eines MOS-Transistors, umfasst, welcher wahlweise
- den zweiten Speicherknoten (K2) mit dem Widerstandselement (R1) elektrisch verbindet oder
- den zweiten Speicherknoten (K2) von dem Widerstandselement (R1) elektrisch entkoppelt.

10. Nichtflüchtige Speicherzelle nach Anspruch 8 und 9,
**dadurch gekennzeichnet, dass**
der erste Schalter (SW4) und der zweite Schalter (SW1) zwei separate Schalter sind.

11. Nichtflüchtige Speicherzelle nach Anspruch 4 oder einem der auf Anspruch 4 rückbezogenen Ansprüche 5 bis 10,
**dadurch gekennzeichnet, dass**
das Mittel zum Initialisieren des Widerstandswerts einen dritten Schalter (SW3), insbesondere in Form eines MOS-Transistors, umfasst, welcher wahlweise
- das Widerstandselement (R1) mit einem ersten Knoten (E) festen Potentials elektrisch verbindet oder
- das Widerstandselement (R1) elektrisch von dem ersten Knoten (E) festen Potentials entkoppelt.

12. Nichtflüchtige Speicherzelle nach auf Anspruch 8 rückbezogenem Anspruch 11,
**dadurch gekennzeichnet, dass**
der erste Schalter (SW4) und der dritte Schalter (SW3) zwei separate Schalter sind.

13. Nichtflüchtige Speicherzelle nach Anspruch 3 oder einem der auf Anspruch 3 rückbezogenen Ansprüche 4 bis 12,
**dadurch gekennzeichnet, dass**
das Mittel zum Initialisieren des Potentials des zweiten Speicherknotens einen vierten Schalter (SW2), insbesondere in Form eines MOS-Transistors, umfasst, welcher wahlweise
- den zweiten Speicherknoten (K2) mit einem zweiten Knoten (C) festen Potentials elektrisch verbindet oder
- den zweiten Speicherknoten (K2) von dem zweiten Knoten (C) festen Potentials entkoppelt.

14. Nichtflüchtige Speicherzelle nach Anspruch 9 oder einem der auf Anspruch 9 rückbezogenen Ansprüche 10 bis 12,
**dadurch gekennzeichnet, dass**
das Mittel (SW1, SW2) zum Wiederabrufen der gesicherten binären Information einen vierten Schalter (SW2), insbesondere in Form eines MOS-Transistors, umfasst, welcher im geschlossenen Zustand den zweiten Speicherknoten (K2) mit einem zweiten Knoten (C) festen Potentials elektrisch verbindet, wobei das Potential an dem zweiten Speicherknoten (K2) bei geschlossenem zweiten (SW1) und vierten Schalter (SW2) der binären Information entspricht.

15. Nichtflüchtige Speicherzelle nach auf Anspruch 5 rückbezogenem Anspruch 13 oder 14,
**dadurch gekennzeichnet, dass**
das flüchtige Speichermittel (INV1, INV2) in einen bestimmten Zustand rücksetzbar ist, wobei der vierte Schalter (SW2; N3) ferner zum Rücksetzen des flüchtigen Speichermittels (INV1, INV2) verwendet wird.

16. Nichtflüchtige Speicherzelle nach den Ansprüchen 8 bis 13 oder nach den Ansprüchen 8 bis 12 und 14,
**dadurch gekennzeichnet, dass**
- der erste Knoten (E) und der zweiten Knoten (C) festen Potentials dem Masseknoten entsprechen,
- das Widerstandselement (R1) an den positiven Betriebsspannungsknoten (VDD) angeschlossen ist und
- der erste Schalter (SW4), der zweite Schalter (SW1), der dritte Schalter (SW3) und der vierte Schalter (SW2) in Form eines NMOS-Transistors, PMOS-Transistors, NMOS-Transistors bzw. NMOS-Transistors implementiert sind.

17. Nichtflüchtige Speicherzelle nach den Ansprüchen 8 bis 13 oder nach den Ansprüchen 8 bis 12 und 14,
**dadurch gekennzeichnet, dass**
- der erste Knoten (E) und der zweiten Knoten (C) festen Potentials dem positiven Betriebsspannungsknoten entsprechen,
- das Widerstandselement an den Masseknoten angeschlossen ist und
- der erste Schalter (SW4), der zweite Schalter (SW1), der dritte Schalter (SW3) und der vierte Schalter (SW2) in Form eines PMOS-Transistors, NMOS-Transistors, PMOS-Transistors bzw. PMOS-Transistors implementiert sind.

18. Nichtflüchtige Speicherzelle nach Anspruch 4 oder einem der auf Anspruch 4 rückbezogenen Ansprüche 5 bis 17,
**dadurch gekennzeichnet, dass**
- das Mittel (SW3) zum Initialisieren des Widerstandswerts den Widerstandswert auf den größeren der beiden programmierbaren Werte initialisiert.

19. Nichtflüchtige Speicherzelle nach Anspruch 4 oder einem der auf Anspruch 4 rückbezogenen Ansprüche 5 bis 17,
**dadurch gekennzeichnet, dass**
- das Mittel (SW3) zum Initialisieren des Widerstandswerts den Widerstandswert auf den kleineren der beiden programmierbaren Werte initialisiert.

20. Nichtflüchtige Speicherzelle nach den Ansprüchen 4 und 8 sowie nach einem der Ansprüche 18 oder 19,
**dadurch gekennzeichnet, dass**
der erste Schalter (SW4) ferner als Teil des Mittels zum Initialisieren des Widerstandswerts zum Initialisieren des Widerstandswerts verwendet wird.

21. Nichtflüchtige Speicherzelle nach einem der vorhergehenden Ansprüche,
**dadurch gekennzeichnet, dass**
die nichtflüchtige Speicherzelle ein Master-Slave-Flipflop mit einer Master-Stufe (M) und einer Slave-Stufe (S) darstellt, wobei das flüchtige Speichermittel insgesamt zwei bistabile Kippstufen umfasst und die Master-Stufe (M) die erste bistabile Kippstufe und die Slave-Stufe (S) die zweite bistabile Kippstufe umfassen.

22. Nichtflüchtige Speicherzelle nach auf Anspruch 2 rückbezogenem Anspruch 21,
**dadurch gekennzeichnet, dass**
der erste Speicherknoten (K1) und der zweite Speicherknoten (K2') Knoten verschiedener Kippstufen sind, wobei insbesondere der erste Speicherknoten (K1) ein Knoten der zweiten Kippstufe und der zweite Speicherknoten (K2') ein Knoten der ersten Kippstufe sind.

23. Nichtflüchtige Speicherzelle nach einem der Ansprüche 2 bis 20,
**dadurch gekennzeichnet, dass**
die nichtflüchtige Speicherzelle ein Master-Slave-Flipflop mit einer Master-Stufe und einer Slave-Stufe darstellt, wobei
- das flüchtige Speichermittel eine einzige bistabile Kippstufe umfasst,
- die Master-Stufe die bistabile Kippstufe umfasst,
- die Slave-Stufe das Widerstandselement, das Mittel zum Sichern der binären Information und das Mittel zum Wiederabrufen der binären Information umfasst.

24. Nichtflüchtige Speicherzelle nach einem der vorhergehenden Ansprüche,
**dadurch gekennzeichnet, dass**
beim Programmieren des Widerstandswerts der Phasenzustand des Widerstandselements (R1) geändert wird, wobei das Widerstandselement (R1)
- in einem amorphen Zustand einen ersten Widerstandswert und
- in einem polykristallinen Zustand einen zweiten Widerstandswert
aufweist, wobei der erste Widerstandswert größer als der zweite Widerstandswert ist.

25. Schieberegister, umfassend eine Mehrzahl hintereinander geschalteter nichtflüchtiger Speicherzellen nach Anspruch 23, wobei für jede nichtflüchtige Speicherzelle das Mittel zum Wiederabrufen der binären Information den Potentialwert eines zweiten Speicherknotens des der jeweiligen Speicherzelle nachgeschalteten Speicherzelle in Abhängigkeit des Widerstandswerts festlegt.

## Claims

1. Non-volatile memory cell, comprising:
- a volatile memory means (INV1, INV2) with one or a plurality of storage nodes (K1, K2) for storing an item of binary information in the form of the potential value of a first storage node (K1), and
- a resistance element (R1) having a binary programmable resistance value for non-volatile saving of the binary information stored in the volatile memory means (INV1, INV2),
- a means (SW3, SW4) for saving the binary information in the resistance element (R1), which is configured in such a way that the resistance value is programmed in a manner dependent on the potential of the first storage node (K1), and
- a means (SW1, SW2) for retrieving the binary information saved in the form of the resistance value, **characterized in that** the resistance element constitutes a single resistance element.

2. Non-volatile memory cell according to Claim 1,
**characterized in that**
the means (SW1, SW2) for retrieving the binary information is configured in such a way that it defines the potential value of a second storage node (K2) - which is not necessarily different from the first storage node (K1) - of this memory cell or of another identical memory cell in a manner dependent on the resistance value.

3. Non-volatile memory cell according to Claim 2,
**characterized in that**
the means (SW1, SW2) for retrieving the binary information comprises:
- a means (SW2) for initializing the potential of the second storage layer (K2) with a fixed value.

4. Non-volatile memory cell according to Claim 2 or 3,
**characterized in that**
the means (SW3, SW4) for saving the binary information comprises:
- a means (SW3) for initializing the resistance value to a specific value of the two programmable values.

5. Non-volatile memory cell according to one of the preceding claims,
**characterized in that**
the volatile memory means comprises a bistable multivibrator in the form of two cross-coupled inverters (INV1, INV2), in particular two cross-coupled CMOS inverters.

6. Non-volatile memory cell according to Claim 5 referred back to Claim 3,
**characterized in that**
the volatile memory means (INV1, INV2) is configured in such a way
- that the second storage node (K2) is electrically connected to the output of an inverter (INV2) of the volatile memory means of this memory cell or of another identical memory cell, it being possible for the output of said inverter (INV2) to be switched in high-resistance fashion or to be decoupled from the second storage node (K2).

7. Non-volatile memory cell according to Claim 6 referred back to Claim 3,
**characterized in that**
- the two cross-coupled inverters (INV1, INV2) are CMOS inverters each having an NMOS transistor (N4, N5) and a PMOS transistor (P4, P5),
- the means (SW2; N3) for initializing the potential of the second storage node (K2), in the case of initializing the potential, connects the second storage node to the earth node in a first configuration or to the positive operating voltage node in a second configuration, while the output of the inverter (INV2) that can be switched in high-resistance fashion is switched in high-resistance fashion, and
- in the inverter (INV2) that can be switched in high-resistance fashion on the output side, only a single additional transistor (N6) is provided for switching the inverter output into a high-resistance state, said transistor
-- being in the first configuration an NMOS transistor, the source-drain path of which is arranged between the earth node and source terminal of the NMOS transistor (N5) and for the same inverter, and which decouples the earth node from the source terminal of the NMOS transistor (N5) of the inverter in the case of a high-resistance output, and
-- being in the second configuration a PMOS transistor, the source-drain path of which is arranged between the positive operating voltage node and the source terminal of the PMOS transistor of the same inverter, and which decouples the positive operating voltage node from the source terminal of the PMOS transistor of the inverter in the case of a high-resistance output.

8. Non-volatile memory cell according to one of Claims 2 to 7,
**characterized in that**
the means (SW3, SW4) for saving the binary information comprises a first switch (SW4) in particular in the form of a MOS transistor, which optionally
- electrically connects the first storage node (K1) to the resistance element (R1) or
- electrically decouples the first storage node (K1) from the resistance element (R1).

9. Non-volatile memory cell according to one of Claims 2 to 8,
**characterized in that**
the means (SW1, SW2) for retrieving the saved binary information comprises a second switch (SW1) in particular in the form of a MOS transistor, which optionally
- electrically connects the second storage node (K2) to the resistance element (R1) or
- electrically decouples the second storage node (K2) from the resistance element (R1).

10. Non-volatile memory cell according to Claims 8 and 9,
**characterized in that**
the first switch (SW4) and the second switch (SW1) are two separate switches.

11. Non-volatile memory cell according to Claim 4, or one of Claims 5 to 10, referred back to Claim 4,
**characterized in that**
the means for initializing the resistance value comprises a third switch (SW3) in particular in the form of a MOS transistor, which optionally
- electrically connects the resistance element (R1) to a first node (E) having a fixed potential or
- electrically decouples the resistance element (R1) from the first node (E) having a fixed potential.

12. Non-volatile memory cell according to Claim 11 referred back to Claim 8,
**characterized in that**
the first switch (SW4) and the third switch (SW3) are two separate switches.

13. Non-volatile memory cell according to Claim 3, or one of Claims 4 to 12, referred back to Claim 3,
**characterized in that**
the means for initializing the potential of the second storage node comprises a fourth switch (SW2) in particular in the form of a MOS transistor which optionally
- electrically connects the second storage node (K2) to a second node (C) having a fixed potential or
- decouples the second storage node (K2) from the second node (C) having a fixed potential.

14. Non-volatile memory cell according to Claim 9, or one of Claims 10 to 12, referred back to Claim 9,
**characterized in that**
the means (SW1, SW2) for retrieving the saved binary information comprises a fourth switch (SW2) in particular in the form of a MOS transistor, which, in the closed state, electrically connects the second storage node (K2) to a second node (C) having a fixed potential, the potential at the second storage node (K2) corresponding to the binary information when the second switch (SW1) and fourth switch (SW2) are closed.

15. Non-volatile memory cell according to Claim 13 or 14, referred back to Claim 5,
**characterized in that**
the volatile memory means (INV1, INV2) can be reset into a specific state, the fourth switch (SW2; N3) furthermore being used for resetting the volatile memory means (INV1, INV2).

16. Non-volatile memory cell according to Claims 8 to 13, or according to Claims 8 to 12 and 14,
**characterized in that**
- the first node (E) and the second node (C) having a fixed potential correspond to the earth node,
- the resistance element (R1) is connected to the positive operating voltage node (VDD), and
- the first switch (SW4), the second switch (SW1), the third switch (SW3) and the fourth switch (SW2) are implemented in the form of an NMOS transistor, PMOS transistor, NMOS transistor and NMOS transistor, respectively.

17. Non-volatile memory cell according to Claims 8 to 13, or according to Claims 8 to 12 and 14,
**characterized in that**
- the first node (E) and the second node (C) having a fixed potential correspond to the positive operating voltage node, and
- the resistance element is connected to the earth node, and
- the first switch (SW4), the second switch (SW1), the third switch (SW3) and the fourth switch (SW2) are implemented in the form of a PMOS transistor, NMOS transistor, PMOS transistor and PMOS transistor, respectively.

18. Non-volatile memory cell according to Claim 4, or one of Claims 5 to 17, referred back to Claim 4,
**characterized in that**
- the means (SW3) for initializing the resistance value initializes the resistance value to the larger of the two programmable values.

19. Non-volatile memory cell according to Claim 4, or one of Claims 5 to 17, referred back to Claim 4,
**characterized in that**
- the means (SW3) for initializing the resistance value initializes the resistance value to the smaller of the two programmable values.

20. Non-volatile memory cell according to Claims 4 and 8, and according to either of Claims 18 and 19,
**characterized in that**
- the first switch (SW4) is furthermore used for initializing the resistance value as part of the means for initializing the resistance value.

21. Non-volatile memory cell according to one of the preceding claims,
**characterized in that**
the non-volatile memory cell constitutes a master-slave flip-flop having a master stage (M) and a slave stage (S), the volatile memory means comprising a total of two bistable multivibrators and the master stage (M) comprising the first bistable multivibrator and the slave stage (S) comprising the second bistable multivibrator.

22. Non-volatile memory cell according to Claim 21, referred back to Claim 2,
**characterized in that**
the first storage node (K1) and the second storage node (K2') are nodes of different multivibrators, in particular the first storage node (K1) being a node of the second multivibrator and the second storage node (K2') being a node of the first multivibrator.

23. Non-volatile memory cell according to one of Claims 2 to 20,
**characterized in that**
the non-volatile memory cell constitutes a master-slave flip-flop having a master stage and a slave stage,
- the volatile memory means comprising a single bistable multivibrator,
- the master stage comprising the bistable multivibrator,
- the slave stage comprising the resistance element, the means for saving the binary information and the means for retrieving the binary information.

24. Non-volatile memory cell according to one of the preceding claims,
**characterized in that**
the phase state of the resistance element (R1) is changed during the programming of the resistance value, the resistance element (R1) having
- a first resistance value in an amorphous state and,
- a second resistance value in a polycrystalline state,
the first resistance value being greater than the second resistance value.

25. Shift register, comprising a plurality of series-connected non-volatile memory cells according to Claim 23, for each non-volatile memory cell the means for retrieving the binary information defining the potential value of a second storage node of the memory cell connected downstream of the respective memory cell in a manner dependent on the resistance value.

## Revendications

1. Cellule de mémoire non volatile comprenant
- un moyen (INV1, INV2) de mémoire volatile ayant un ou plusieurs noeuds (K1, K2) de mémoire pour mémoriser une information binaire sous la forme de la valeur du potentiel d'un premier noeud (K1) de mémoire,
- un élément (R1) résistif ayant une valeur de résistance programmable de manière binaire pour la sauvegarde non volatile de l'information binaire mémorisée dans le moyen (INV1, INV2) de mémoire volatile,
- un moyen (SW3, SW4) de sauvegarde de l'information binaire dans l'élément (R1) résistif qui est tel que la valeur de la résistance est programmée en fonction du potentiel du premier noeud (K1) de mémoire, et
- un moyen (SW1, SW2) de rappel de l'information binaire sauvegardée sous la forme de la valeur de la résistance, **caractérisée en ce que** l'élément résistif constitue un élément résistif unique.

2. Cellule de mémoire non volatile suivant la revendication 1,
**caractérisé en ce que**
le moyen (SW1, SW2) de rappel de l'information binaire est tel qu'il fixe la valeur de potentiel d'un deuxième noeud (K2) de mémoire, qui n'est pas nécessairement différent du premier noeud (K1) de mémoire, de cette cellule de mémoire ou d'une autre cellule de mémoire identique en fonction de la valeur de la résistance.

3. Cellule de mémoire non volatile suivant la revendication 2,
**caractérisée en ce que**
le moyen (SW1, SW2) de rappel de l'information binaire comprend:
- un moyen (SW2) d'initialisation du potentiel du deuxième noeud (K2) de mémoire par une valeur fixe.

4. Cellule de mémoire non volatile suivant la revendication 2 ou 3,
**caractérisée en ce que**
le moyen (SW3, SW4) de sauvegarde de l'information binaire comprend :
- un moyen (SW3) d'initialisation de la valeur de la résistance sur une valeur déterminée des deux valeurs programmables.

5. Cellule de mémoire non volatile suivant l'une des revendications précédentes,
**caractérisée en ce que** le moyen de mémoire volatile comprend une bascule bistable sous la forme de deux inverseurs (INV1, INV2) couplés en croix, notamment de deux inverseurs C-MOS couplés en croix.

6. Cellule de mémoire non volatile suivant la revendication 5 rapportée à la revendication 3,
**caractérisée en ce que**
le moyen (INV1, INV2) de mémoire volatile est tel que
- le deuxième noeud (K2) de mémoire est relié électriquement à la sortie d'un inverseur (INV2) du moyen de mémoire volatile de cette cellule de mémoire ou d'une autre cellule de mémoire identique, la sortie de cet inverseur (INV2) pouvant être mise en circuit à grande valeur ohmique ou pouvant être découplée du deuxième noeud (K2) de mémoire.

7. Cellule de mémoire non volatile suivant la revendication 6, rapportée à la revendication 3,
**caractérisée en ce que**
- les deux inverseurs (INV1, INV2) couplés en croix sont des inverseurs C-MOS ayant respectivement un transistor NMOS (N4, N5) et un transistor PMOS (P4, P5), et
- le moyen (SW2, N3) d'initialisation du potentiel du deuxième noeud (K2) de mémoire relie, lors de l'initialisation du potentiel du deuxième noeud de mémoire, dans une première conformation au noeud à la masse ou dans une deuxième conformation au noeud de tension de fonctionnement positif, tandis que la sortie de l'inverseur (INV2), pouvant être monté à grande valeur ohmique, est montée à grande valeur ohmique, et
- dans l'inverseur (INV2) pouvant être monté à grande valeur ohmique du côté sortie, pour mettre la sortie de l'inverseur dans un état à grande valeur ohmique, il est prévu simplement un transistor (N6) supplémentaire unique, dans lequel ce transistor
-- est, dans la première conformation, un transistor NMOS, dont la zone de source-drain est disposée entre le noeud de masse et la borne de source du transistor (N5) NMOS du même inverseur et qui, à grande valeur ohmique, découple le noeud à la masse de la borne de source du transistor NMOS (N5) de l'inverseur, et
-- est, dans la deuxième conformation, un transistor PMOS dont la zone de source-drain est montée entre le noeud de tension de fonctionnement positif et la borne de source du transistor PMOS du même inverseur et qui, à grande valeur ohmique, découple le noeud de tension de fonctionnement positif de la borne de source du transistor PMOS de l'inverseur.

8. Cellule de mémoire non volatile suivant l'une des revendications 2 à 7,
**caractérisée en ce que**
le moyen (SW3, SW4) de sauvegarde de l'information binaire comprend un premier interrupteur (SW4), notamment sous la forme d'un transistor MOS, qui au choix
- relie électriquement le premier noeud (K1) de mémoire à l'élément (R1) résistif ou
- découple électriquement le premier noeud (K1) de mémoire de l'élément (R1) résistif.

9. Cellule de mémoire non volatile suivant l'une des revendication 2 à 8,
**caractérisée en ce que**
le moyen (SW1, SW2) de rappel de l'information binaire sauvegardée comprend un deuxième interrupteur (SW1), notamment sous la forme d'un transistor MOS, qui au choix
- relie électriquement le deuxième noeud (K2) de mémoire à l'élément (R1) résistif pour
- découple électriquement le deuxième noeud (K2) de mémoire de l'élément (R1) résistif.

10. Cellule de mémoire non volatile suivant la revendication 8 et 9,
**caractérisée en ce que**
le premier interrupteur (SW4) et le deuxième interrupteur (SW1) sont deux interrupteurs distincts.

11. Cellule de mémoire non volatile suivant la revendication 4, ou l'une des revendications 5 à 10, rapportées à la revendication 4,
**caractérisée en ce que**
le moyen d'initialisation de la valeur de résistance comprend un troisième interrupteur (SW3), notamment sous la forme d'un transistor MOS, qui au choix
- relie électriquement l'élément (R1) résistif à un premier noeud (E) de potentiel fixe ou
- découple l'élément (R1) résistif électriquement du premier noeud (E) de potentiel fixe.

12. Cellule de mémoire non volatile suivant la revendication 11, rapportée à la revendication 8,
**caractérisée en ce que**
le premier interrupteur (SW4) et le troisième interrupteur (SW3) sont deux interrupteurs distincts.

13. Cellule de mémoire non volatile suivant la revendication 3, ou l'une des revendications 4 à 12, rapportées à la revendication 3,
**caractérisée en ce que**
le moyen d'initialisation du potentiel du deuxième noeud de mémoire comprend un quatrième interrupteur (SW1), notamment sous la forme d'un transistor MOS, qui au choix
- relie électriquement le deuxième noeud (K2) de mémoire à un deuxième noeud (C) de potentiel fixe ou
- découple le deuxième noeud (K2) de mémoire du deuxième noeud (C) de potentiel fixe.

14. Cellule de mémoire non volatile suivant la revendication 9, ou l'une des revendications 10 à 12 rapportées à la revendications 9,
**caractérisée en ce que**
le moyen (SW1, SW2) de rappel de l'information binaire sauvegardée comprend un quatrième interrupteur (SW2), notamment sous la forme d'un transistor MOS, qui à l'état fermé relie électriquement le deuxième noeud (K2) de mémoire à un deuxième noeud (C) de potentiel fixe, le potentiel sur le deuxième noeud (K2) de mémoire correspondant, lorsque le deuxième (SW1) et le quatrième (SW2) commutateurs sont fermés, à l'information binaire.

15. Cellule de mémoire non volatile suivant la revendication 13 ou 14, rapportées à la revendication 5,
**caractérisée en ce que**
le moyen (INV1, INV2) de mémoire volatile peut être remis à l'état initial dans un certain état, le quatrième interrupteur (SW2, N3) étant utilisé en outre pour remettre à l'état initial le moyen (INV1 , INV2) de mémoire volatile.

16. Cellule de mémoire non volatile suivant les revendications 8 à 13, suivant les revendications 8 à 12 et 14,
**caractérisée en ce que**
- le premier noeud (E) et le deuxième noeud (C) de potentiel fixe correspondent au noeud à la masse,
- l'élément (R1) résistif est relié aux noeuds (VDD) de tension de fonctionnement positifs, et
- le premier interrupteur (SW4), le deuxième interrupteur (SW1), le troisième interrupteur (SW3) et le quatrième interrupteur (SW2) sont mis en oeuvre sous la forme d'un transistor MOS, d'un transistor PMOS, d'un transistor NMOS et respectivement d'un transistor NMOS.

17. Cellule de mémoire non volatile suivant les revendications 8 à 13 ou suivant les revendications 8 à 12 et 14,
**caractérisée en ce que**
- le premier noeud (E) et le deuxième noeud (C) de potentiel fixe correspondent aux noeuds de tension de fonctionnement positifs,
- l'élément résistif est raccordé au noeud à la masse, et
- le premier interrupteur (SW4), le deuxième interrupteur (SW1), le troisième interrupteur (SW3) et le quatrième interrupteur (SW2) sont mis en oeuvre sous la forme d'un transistor PMOS, d'un transistor NMOS, d'un transistor PMOS, et respectivement d'un transistor PMOS

18. Cellule de mémoire non volatile suivant la revendication 4 ou l'une des revendications 5 à 17, rapportées à la revendication 4,
**caractérisée en ce que**
- le moyen (SW3) d'initialisation de la valeur de la résistance initialise la valeur de la résistance sur la plus grande des deux valeurs programmables.

19. Cellule de mémoire non volatile suivant la revendication 4, ou l'une des revendications 5 à 17, rapportées à la revendication 4,
**caractérisée en ce que**
- le moyen (SW3) d'initialisation de la valeur de la résistance initialise la valeur de la résistance sur la plus petite des deux valeurs programmables.

20. Cellule de mémoire non volatile suivant les revendications 4 et 8 ainsi que suivant l'une des revendications 18 ou 19,
**caractérisée en ce que**
le premier interrupteur (SW4) est utilisé en outre comme partie du moyen d'initialisation de la valeur de la résistance pour initialiser la valeur de la résistance.

21. Cellule de mémoire non volatile suivant l'une des revendications précédentes,
**caractérisée en ce que**
la cellule de mémoire non volatile représente une bascule maître-esclave ayant un étage (M) maître et un étage (S) esclave, le moyen de mémoire volatile comprenant dans l'ensemble deux bascules bistables et l'étage (M) maître comprenant la première bascule bistable, l'étage (S) esclave, la deuxième bascule bistable.

22. Cellule de mémoire non volatile suivant la revendication 21, rapportée à la revendication 2,
**caractérisée en ce que**
le premier noeud (K1) de mémoire et le deuxième noeud (K2') de mémoire sont des bascules différentes, le premier noeud (K1) de mémoire étant notamment un noeud du premier étage de la bascule et le deuxième noeud (K2') de mémoire un noeud du premier étage de la bascule.

23. Cellule de mémoire non volatile suivant l'une des revendications 2 à 20,
**caractérisée en ce que**
la cellule de mémoire non volatile est une bascule maître-esclave ayant un étage maître et un étage esclave dans laquelle
- le moyen de mémoire volatile comprend un étage de bascule bistable unique,
- l'étage maître comprend l'étage de bascule bistable,
- l'étage esclave comprend l'élément résistif, le moyen de sauvegarde de l'information binaire et le moyen de rappel de l'information binaire.

24. Cellule de mémoire non volatile suivant l'une des revendications précédentes,
**caractérisée en ce que**
lors de la programmation de la valeur de la résistance, l'état de phase de l'élément (R1) résistif est modifié, l'élément (R1) résistif,
- ayant dans un état amorphe une première valeur de résistance et dans un état polycristallin une deuxième valeur de résistance, la première valeur de résistance étant plus grande que la deuxième valeur de résistance.

25. Registre à décalage, comprenant une multiplicité de cellules de mémoire non volatile montées les unes derrière les autres suivant la revendication 23, dans lequel, pour chaque cellule de mémoire non volatile, le moyen de rappel de l'information binaire fixe la valeur de potentiel d'un deuxième noeud de mémoire de la cellule de mémoire en aval de la cellule de mémoire respective, en fonction de la valeur de la résistance.
